# EUROPEAN PATENT APPLICATION

(11) **EP 4 249 109 A1**
(43) Date of publication of application: **27.09.2023**
(21) Application number: 21894769.5
(22) Date of filing: 22.11.2021
(51) Int. Cl.: B01F 23/41, B01F 25/40, B81B 1/00, B01J 13/00, B01J 19/00

(54) **MICRO TWO-PHASE LIQUID DROPLET GENERATION DEVICE**

(30) Priority: 20.11.2020 JP 2020193256
(71) Applicant: Japan Science and Technology Agency, Kawaguchi-shi, Saitama 332-0012 (JP)
(72) Inventor: NISISAKO, Takashi, Tokyo 152-8550 (JP)
(74) Representative: Vossius & Partner Patentanwälte Rechtsanwälte mbB
(86) International application number: PCT/JP2021/042781
(87) International publication number: WO 2022/107898

(57) **Abstract**

The present invention provides a micro two-phase droplet generating device that does not require separate through-holes corresponding to a plurality of two-phase dispersed parallel continuous flow channels. The micro two-phase droplet generating device of the present application comprises a row of a plurality of microflow channels, liquid transfer ports, and a slit, and is configured so as to form two-dispersion phase parallel continuous flows at first connection sites between the plurality of microflow channels, in which a first dispersion phase flows, and the slit, through which a second dispersion phase flows. A continuous phase is fed to second connection sites between the plurality of microflow channels, in which the two-dispersion phase parallel continuous flows flow, and another liquid transfer port, which is preferably a second slit, downstream of the slit, and the two-dispersion phase parallel continuous flows are sheared at the second connection sites, whereby two-phase droplets, and in particular, core-shell or Janus two-phase droplets, can be generated, and a product can be collected from a discharge port.

## Description

### FIELD

The present invention relates to a device for generating micro two-phase droplets.

### BACKGROUND

The present inventors have developed an emulsion generating method which utilizes the intersecting shape of microchannels as a method for generating fine droplets (emulsion) having excellent size uniformity (mono-dispersity). With this technology, it has become possible to generate emulsions of uniform size, and to flexibly control the droplet diameter and generation rate of an emulsion by manipulating the flow speed in the channels. The present inventors have also developed a device comprising a microchannel substrate having a large number of intersecting microchannels for droplet generation and a microchannel substrate holder with a hierarchical structure for controlling the distribution of liquid to each microchannel (Patent Literature 1) as well as a droplet generating device which three-dimensionally combines a row of a plurality of microflow channels and slits arranged in a direction perpendicular to the row (Patent Literature 2).

Microdroplet generation technology is also applied to the generation of emulsions in which microdroplets are composed of a plurality of dispersion phases. Specifically, it is known that, for example, a two-dispersion phase parallel continuous flow forms using a Y-shaped microchannel, and core-shell or Janus two-phase droplets are generated by shearing the two-dispersion phase parallel continuous flow with a continuous flow from a direction perpendicular to the two-dispersion phase parallel continuous flow in the same plane as the Y-shaped microchannel (Non-Patent Literature 1).

However, in such a two-phase droplet production device, there is an upper limit to the flow rate at which droplets can be generated with a single microchannel crossing structure, and there is a problem in that the processing amount is small. Conversely, when a plurality of microchannel structures for forming two-dispersion phase parallel continuous flows and generating two-phase droplets are arranged on a microchannel substrate in order to improve the processing amount, as the plurality of inlets (liquid supply ports) for supplying two dispersion phases and a continuous phase from the outside of the substrate to each channel inside the microchannel substrate, it is necessary to provide a plurality of individual through-holes in the substrate for connecting the respective channels inside the substrate and the outside of the substrate. Furthermore, it is necessary to use a the microchannel substrate holder in combination, which has liquid supply channels corresponding to the plurality of liquid supply ports of the substrate. Thus, conventional microchannels arranged two-dimensionally using Y-shaped microchannels require a device with a complicated structure to generate large quantities of two-phase droplets, and it is difficult to generate large quantities with a simple device.

### [CITATION LIST]

### [PATENT LITERATURE]

[PTL 1] WO2007/026564
[PTL 2] WO2019/168130

### [NON-PATENT LITERATURE]

[NPL 1] Microfluidics and Nanofluidics (2010), 9, pp. 427-437

### SUMMARY

### [TECHNICAL PROBLEM]

In order to solve the problems described above, an object of the present invention is to provide a micro two-phase droplet generating device which, unlike a conventional two-phase droplet generation device having Y-shaped flow channels adapted for forming two-dispersion phase parallel continuous flows and arranged in a two-dimensional plane, has a simple construction where slits and a microflow channel array are combined in a three-dimensional manner, allowing easier mounting and management and having two-dispersion phase parallel continuous flow forming parts arranged at a higher density than in the prior art.

### [SOLUTION TO PROBLEM]

The present invention provides, by confirming that micro two-phase droplets can be generated by a simple construction where slits and a microflow channel array are combined in a three-dimensional manner, a device for micro two-phase droplet generation which allows easier mounting and management and has two-dispersion phase parallel continuous flow forming parts arranged at a higher density than in the prior art.

Suitable aspects of the present invention are described below.

### (Aspect 1)

A micro two-phase droplet generating device (100), comprising:
a row of a plurality of microflow channels (16), and
a first liquid transfer port (11), a first slit (12), a second liquid transfer port (13), and a third liquid transfer port (14) arranged in this order in a longitudinal direction of the microflow channels (16), wherein
"slit" is defined as a structure which has a linear end surface having a width and an axis line having a dimension larger than the width in a reference plane where the row of the plurality of microflow channels (16) is present, the row of the plurality of microflow channels (16) is present on the reference plane, the row of the plurality of microflow channels (16) is connected on the reference plane to the slit (12) having an end on the reference plane, and the slit (12) terminates at the reference plane and extends transversely below the reference plane,
the first slit (12) constitutes a part of a second phase dispersion phase supply port (12-1), the second liquid transfer port (13) constitutes a part of a continuous phase supply port or a discharge port, and the first slit (12) and the second liquid transfer port (13) terminate at connection sites thereof with the plurality of microflow channels (16),
at the plane where the ends of the first slit (12) and the second liquid transfer port (13) are present, the plurality of microflow channels (16) are arranged so as to connect the end of the first liquid transfer port (11) and the end of the first slit (12), to connect the end of the first slit (12) and the end of the second liquid transfer port (13), and to connect the end of the second liquid transfer port (13) and the end of the third liquid transfer port (14), wherein the second liquid transfer port (13) is the continuous phase supply port or the discharge port, the third liquid transfer port (14) is the discharge port when the second liquid transfer port (13) is the continuous phase supply port, and the third liquid transfer port (14) is the continuous phase supply port when the second liquid transfer port (13) is the discharge port,
a first dispersion phase (1) is supplied from the first liquid transfer port (11) to the plurality of microflow channels (16), a second dispersion phase (2) is supplied from the first slit (12) to the plurality of microflow channels (16), wherein the first dispersion phase (1) and the second dispersion phase (2) are liquids which are not completely miscible with each other,
in the microflow channels (16) connecting the end of the first slit (12) and the end of the second liquid transfer port (13), the first dispersion phase (1) and the second dispersion phase (2) form a two-phase parallel continuous flow (4) which contains the two phases of the first dispersion phase (1) and the second dispersion phase (2) in parallel,
a continuous phase (3) is supplied to the plurality of microflow channels (16) from one of the second liquid transfer port (13) and the third liquid transfer port (14),
at the connection sites between the second liquid transfer port (13) and the plurality of microflow channels (16), two-phase droplets (5) are generated from the first dispersion phase (1) and the second dispersion phase (2), and
a product (6) containing the two-phase droplets (5) is collected from the other one of the second liquid transfer port (13) and the third liquid transfer port (14).

### (Aspect 2)

The micro two-phase droplet generating device according to Aspect 1, wherein the second liquid transfer port (13) is a second slit, the second slit (13) satisfies the above definition of "slit", and at connection sites between the second liquid transfer port (13) and the plurality of microflow channels (16), the two-phase parallel continuous flow (4) is sheared using a flow of the continuous phase (3) as a driving force to generate the two-phase droplets (5).

### (Aspect 3)

The micro two-phase droplet generating device according to Aspect 1 or 2, wherein the two-phase droplets (5) are core-shell two-phase droplets.

### (Aspect 4)

The micro two-phase droplet generating device according to Aspect 1 or 2, wherein the two-phase droplets (5) are Janus two-phase droplets.

### (Aspect 5)

The micro two-phase droplet generating device according to any one of Aspects 1 to 4, wherein an end of the first liquid transfer port (11), an end of the second liquid transfer port (13), and/or an end of the third liquid transfer port (14) is/are slit-shaped.

### (Aspect 6)

The micro two-phase droplet generating device according to any one of Aspects 1 to 5, wherein the slit(s) (11, 12, 13, 14) including the first slit (12) is/are a flat slit.

### (Aspect 7)

The micro two-phase droplet generating device according to any one of Aspects 1 to 5, wherein the slit(s) (11, 12, 13, 14) including the first slit (12) is/are an annular slit.

### (Aspect 8)

The micro two-phase droplet generating device according to Aspect 6 or 7, wherein a part (30, 41, 43) having the first slit (12) and a flat plate part (20, 22, 24) manufactured to have thereon a row of a plurality of microgrooves (16, 16-2, 16-4) are aligned with each other, and the plurality-of-slits-end side surface of the part and the microgrooves-end side surface of the flat plate part (20, 22, 24) are joined together.

### (Aspect 9)

The micro two-phase droplet generating device according to Aspect 6 or 7, wherein the row of the plurality of microgrooves (16) are manufactured on a surface of a part (33, 42, 44) having the first slit (12) and the microgrooves (16-1, 16-3, 16-5) are sealed by a separate flat plate part (21, 23, 25) to form the row of the plurality of microflow channels.

### (Aspect 10)

The micro two-phase droplet generating device according to any one of Aspects 1 to 9, wherein inner walls of the microflow channels (16) are composed of a hydrophilic surface, the first dispersion phase (1) is an organic phase, the second dispersion phase (2) is an organic phase, the continuous phase is an aqueous phase, and core-shell or Janus microdroplets are generated.

### (Aspect 11)

The micro two-phase droplet generating device according to any one of Aspects 1 to 9, wherein an inner wall of the second liquid transfer port (13) is composed of a hydrophilic surface, the first dispersion phase (1) is an organic phase, the second dispersion phase (2) is an organic phase, the continuous phase is an aqueous phase, and core-shell or Janus microdroplets are generated.

### (Aspect 12)

The micro two-phase droplet generating device according to any one of Aspects 1 to 9, wherein inner walls of the microflow channels (16) connecting the end of the first slit (12) and the end of the second liquid transfer port (13) are composed of a hydrophobic surface, inner walls of the microflow channels (16) connecting the end of the second liquid transfer port (13) and the end of the third liquid transfer port (14) are composed of a hydrophilic surface, one of the first dispersion phase (1) and the second dispersion phase (2) is an aqueous phase, the other one of the first dispersion phase (1) and the second dispersion phase (2) is an organic phase, the continuous phase (3) is an aqueous phase, the continuous phase (3) is supplied from the second liquid transfer port (13) to the microflow channels (16), and core-shell microdroplets having an aqueous phase as a core and an organic phase as a shell are generated.

### (Aspect 13)

The micro two-phase droplet generating device according to any one of Aspects 1 to 9, wherein inner walls of the microflow channels (16) connecting the end of the first slit (12) and the end of the second liquid transfer port (13) are composed of a hydrophobic surface, an inner wall of the second liquid transfer port (13) is composed of a hydrophilic surface, one of the first dispersion phase (1) and the second dispersion phase (2) is an aqueous phase, the other one of the first dispersion phase (1) and the second dispersion phase (2) is an organic phase, the continuous phase (3) is an aqueous phase, the continuous phase (3) is supplied from the third liquid transfer port (14) to the microflow channels (16), and core-shell microdroplets having an aqueous phase as a core and an organic phase as a shell are generated.

### (Aspect 14)

The micro two-phase droplet generating device according to any one of Aspects 1 to 3 and 5 to 13, wherein when the first dispersion phase is defined as phase 1, the continuous phase is defined as phase 2, and the second dispersion phase is defined as phase 3, the interfacial tension between the phases 1 and 2 is denoted as γ₁₂, the interfacial tension between the phases 1 and 3 is denoted as γ₁₃, and the interfacial tension between the phases 2 and 3 is denoted as γ₂₃, γ₁₂ > γ23; a spreading parameter Si defined by Si = γⱼₖ - (γᵢⱼ + yki) [where i, j and k are one of 1, 2 and 3 and are different from each other] is S₁ < 0, S₂ < 0, and S₃ > 0; and core-shell microdroplets are generated.

### (Aspect 15)

The micro two-phase droplet generating device according to any one of Aspects 1, 2, and 4 to 11, wherein when the first dispersion phase is defined as phase 1, the continuous phase is defined as phase 2, and the second dispersion phase is defined as phase 3, the interfacial tension between the phases 1 and 2 is denoted as γ₁₂, the interfacial tension between the phases 1 and 3 is denoted as γ₁₃, and the interfacial tension between the phases 2 and 3 is denoted as γ₂₃, γ₁₂ > γ₂₃; a spreading parameter Si defined by Sᵢ = γⱼₖ - (γᵢⱼ + γₖᵢ) [where i, j and k are one of 1, 2 and 3 and are different from each other] is S₁ < 0, S₂ < 0, and S₃ < 0; and Janus microdroplets are generated.

### [ADVANTAGEOUS EFFECTS OF INVENTION]

The present invention provides a micro two-phase droplet generating device that does not require separate through-holes corresponding to the respective two-dispersion phase parallel continuous flow channels. Further, the present invention provides a micro two-phase droplet generating device which, unlike a conventional device having a Y-shaped flow channel adapted for forming the two-dispersion phase parallel continuous flow and arranged in a two-dimensional plane, has a simple construction where slits and a microflow channel array are combined in a three-dimensional manner, allowing easier mounting and management and having two-dispersion phase parallel continuous flow forming parts arranged at a higher density than in the prior art.

### BRIEF DESCRIPTION OF DRAWINGS

FIG. 1 is a schematic perspective view showing embodiment 1 of a micro two-phase droplet generating device.
FIGS. 2a and 2b show embodiment 1 of the micro two-phase droplet generating device, where FIG. 2a is an exploded perspective view of a microgroove array substrate and a liquid distribution part, and FIG. 2b is a plan view and cross-sectional view of the microgroove array substrate and the liquid distribution part.
FIG. 3a is a schematic cross-sectional view of the micro two-phase droplet generating device of embodiment 1, showing an aspect in which a two-phase parallel continuous flow is formed by a microflow channel and a slit to generate two-phase droplets, and FIG. 3b is a schematic cross section of the micro two-phase droplet generating device of embodiment 2, in which a two-phase parallel continuous flow is formed by a microflow channel and a slit to generate two-phase droplets.
FIGS. 4a to 4e are a diagram showing examples of groove shapes of a part having microgrooves, which is joined to a liquid distribution device of the present invention.
FIGS. 5a and 5b show embodiment 3 of the micro two-phase droplet generating device, where FIG. 5a) is an exploded perspective view of a microgroove sealing cover and a liquid distribution part modified with microgrooves, and FIG. 5b is a plan view and cross-sectional view of the microgroove sealing cover and the liquid distribution part.
FIG. 6a is a schematic cross-sectional view of the micro two-phase droplet generating device of embodiment 3, showing an aspect in which a two-phase parallel continuous flow is formed by a microflow channel and a slit to generate two-phase droplets, and FIG. 6b is a schematic cross-sectional view of the micro two-phase droplet generating device of embodiment 4, showing an aspect in which a two-phase parallel continuous flow is formed by a microflow channel and a slit to generate two-phase droplets.
FIGS. 7a to 7e are a view showing examples of the shape of the slits and microgrooves of a liquid distribution device of the present invention.
FIGS. 8a and 8b shows embodiment 5 of the micro two-phase droplet generating device, where FIG. 8a is a partial cross-sectional perspective view of an annular liquid distribution device after assembly of four members, and FIG. 8b is a top view when a part having microgrooves and the liquid distribution device are joined.
FIG. 9a is a schematic cross-sectional view of the micro two-phase droplet generating device of embodiment 5, showing an aspect in which a two-phase parallel continuous flow is formed by a microflow channel and a slit to generate two-phase droplets, and FIG. 9b is a schematic cross-sectional view of the micro two-phase droplet generating device of embodiment 6, showing an aspect in which a two-phase parallel continuous flow is formed by a microflow channel and a slit to generate two-phase droplets.
FIGS. 10a and 10b show embodiment 7 of the micro two-phase droplet generating device, where FIG. 10a is a cross-sectional view of an annular liquid distribution device after assembly of four members, and FIG. 10b is a top view when a cover is joined to the liquid distribution device modified with microgrooves.
FIG. 11a is a schematic cross-sectional view of the micro two-phase droplet generating device of embodiment 7, showing an aspect in which a two-phase parallel continuous flow is formed by a microflow channel and a slit to generate two-phase droplets, and FIG. 11b is a schematic cross section of the micro two-phase droplet generating device of embodiment 8, showing an aspect in which a two-phase parallel continuous flow is formed by a microflow channel and a slit to generate two-phase droplets.
FIG. 12 shows a perspective view of the micro two-phase droplet generating device of embodiment 9 including a cross-section of the annular liquid distribution device after assembly of five members (joining the liquid distribution device to a part having microgrooves).
FIG. 13 shows a perspective view of the micro two-phase droplet generating device of embodiment 10 including a cross-section of the annular liquid distribution device after assembly of five members (joining a cover to the liquid distribution device modified with microgrooves).
FIG. 14 shows the state of core-shell two-phase droplet generation of Example 1 (two-dispersion phase flow rate (Qm) = (Qs) = 6 mL/h, continuous phase flow rate (Qc) =30 mL/h).
FIG. 15 shows photographs and a size distribution of core-shell two-phase droplets generated in Example 1 captured outside the device.
FIG. 16-1 shows the state of Janus two-phase droplet generation of Example 2 (two dispersion phase flow rate (Qm) = (Qs) = 6 mL/h, continuous phase flow rate (Qc) = 30 mL/h).
FIG. 16-2 shows a photograph of the Janus two-phase droplets generated in Example 2 captured outside the device.
FIG. 17a shows a photograph of the Janus two-phase droplets generated in Example 3 captured outside the device, and FIG. 17b shows the size distribution (second dispersion phase flow rate (Qm) = 8 mL/h, (Qs) = 4 mL/h, continuous phase flow rate (Qc) = 30 mL/h).

### DESCRIPTION OF EMBODIMENTS

The present invention provides:
a micro two-phase droplet generating device (100), comprising:
a row of a plurality of microflow channels (16), and
a first liquid transfer port (11), a first slit (12), a second liquid transfer port (13), and a third liquid transfer port (14) arranged in this order in a longitudinal direction of the microflow channels (16), wherein
"slit" is defined as a structure which has a linear end surface having a width and an axis line having a dimension larger than the width in a reference plane where the row of the plurality of microflow channels (16) is present, the row of the plurality of microflow channels (16) is present on the reference plane, the row of the plurality of microflow channels (16) is connected on the reference plane to the slit (12) having an end on the reference plane, and the slit (12) terminates at the reference plane and extends transversely below the reference plane,
the first slit (12) constitutes a part of a second dispersion phase supply port (12-1), the second liquid transfer port (13) constitutes a part of a continuous phase supply port or a discharge port, and the first slit (12) and the second liquid transfer port (13) terminate at connection sites with the plurality of microflow channels (16),
at the plane where the ends of the first slit (12) and the second liquid transfer port (13) are present, the plurality of microflow channels (16) are arranged so as to connect the end of the first liquid transfer port (11) and the end of the first slit (12), to connect the end of the first slit (12) and the end of the second liquid transfer port (13), and to connect the end of the second liquid transfer port (13) and the end of the third liquid transfer port (14), wherein the second liquid transfer port (13) is the continuous phase supply port or the discharge port, the third liquid transfer port (14) is the discharge port when the second liquid transfer port (13) is the continuous phase supply port, and the third liquid transfer port (14) is the continuous phase supply port when the second liquid transfer port (13) is the discharge port,
a first dispersion phase (1) is supplied from the first liquid transfer port (11) to the plurality of microflow channels (16), a second dispersion phase (2) is supplied from the first slit (12) to the plurality of microflow channels (16), wherein the first dispersion phase (1) and the second dispersion phase (2) are liquids which are not completely miscible with each other,
in the microflow channels (16) connecting the end of the first slit (12) and the end of the second liquid transfer port (13), the first dispersion phase (1) and the second dispersion phase (2) form a two-phase parallel continuous flow (4) which contains the two phases of the first dispersion phase (1) and the second dispersion phase (2) in parallel,
a continuous phase (3) is supplied to the plurality of microflow channels (16) from one of the second liquid transfer port (13) and the third liquid transfer port (14),
at the connection sites between the second liquid transfer port (13) and the plurality of microflow channels (16), two-phase droplets (5) are generated from the first dispersion phase (1) and the second dispersion phase (2), and
a product (6) containing the two-phase droplets (5) is collected from the other of the second liquid transfer port (13) and the third liquid transfer port (14).

The micro two-phase droplet generating device of the present invention comprises a row of microflow channels and at least one slit. In the present invention, three liquid transfer ports are provided along with the above one slit, and the ends of these three liquid transfer ports can be one, two, or three slits.

### (Microflow channels)

In the present invention, the sizes of the microflow channels can be determined in accordance with application, and the width and height are usually selected from about 0.1 to 1000 µm, preferably from about 1 to 500 µm, and more preferably from about 10 to 100 µm. The cross-sectional shapes of the microflow channels are not particularly limited, but are preferably selected from rectangular, trapezoidal, triangular, semicircular, circular, elliptical, and semielliptical in accordance with the material of the workpiece and the machining means.

In the present invention, the lengths of the microflow channels can be determined in accordance with application, and are usually selected from about 0.1 to 100 mm, preferably about 1 to 50 mm, and more preferably about 2 to 20 mm.

In the present invention, the arrangement of the row of the plurality of microflow channels is not limited, but may be, for example, side-by-side (the flow paths may be arranged side-by-side without intersecting each other while the intervals between them may not be constant), parallel (constant intervals between channels), or radial.

In the present invention, the intervals between microflow channels of the row of the plurality of microflow channels can be determined in accordance with application, and at the narrowest part, are usually selected from about 0.1 to 1000 µm, preferably about 1 to 500 µm, and more preferably about 10 to 200 µm.

In the present invention, the number of the plurality of microflow channels can be determined in accordance with application, and is usually selected from 2 to 100,000, preferably 10 to 50,000, and more preferably 100 to 10,000.

### (Slit(s), Liquid Transfer Ports)

In the present invention, each slit has a line shape slit end surface having a width and an axis line (slit length) having a dimension larger than the width in a reference plane (in particular a reference flat plane; a virtual plane, but may also be a real plane), the reference plane is a surface, on which the row of the plurality of microflow channels is present, and each slit terminates at the reference plane and extends transversely and downwardly from the reference plane. The shape of the end surface of the slit is not particularly limited, and may be, for example, linear or annular. The transverse dimension of the slit can also be referred to as the depth (height) of the slit. The transverse dimension of the slit is significantly larger than the dimension of the microflow channels in the same direction, and may be, for example, 3 or more, 6 or more, 10 or more-fold greater than the dimension of the microflow channels.

The row of the plurality of microflow channels is present at upper side of the reference plane described above, and the row of the plurality of microflow channels is connected at the reference plane to slit(s) that terminate(s) at the reference plane. In other words, the plurality of microflow channels have connection sites with the slit(s) at the reference plane.

The micro two-phase droplet generating device of the present invention has a first dispersion phase supply port, a second dispersion phase supply port, a continuous phase supply port, and a discharge port. The first dispersion phase supply port is a transportation path through which a first dispersion phase is supplied to the plurality of microflow channels. The second dispersion phase supply port is a transportation path through which a second dispersion phase is supplied to the plurality of microflow channels and which has connection sites with the plurality of microflow channels. The continuous phase supply port is a transportation path through which a continuous phase is supplied to the plurality of microflow channels and which has connection sites with a plurality of microflow channels. The discharge port is a transportation path through which droplet products generated from the plurality of microflow channels are discharged and which has connection sites with the plurality of microflow channels.

The first dispersion phase supply port, the second dispersion phase supply port, and the continuous phase supply port are respectively connected to a first dispersion phase supply source, a second dispersion phase supply source, and a continuous phase supply source for supplying a first dispersion phase, a second dispersion phase, and a continuous phase, such as tanks. The discharge port is connected to a means for collecting and containing the generated two-phase droplet products.

In the present invention, as the slit, at least one slit (the first slit) is included, and the first slit is a second dispersion phase supply slit. However, in the present invention, as the slit, in addition to the first slit, there may be included slit(s) serving as the end(s) of a first liquid transfer port (liquid transfer port for the first dispersion phase supply), a second liquid transfer port (liquid transfer port for continuous phase supply or for discharge), and/or a third liquid transfer port (liquid transfer port for discharge or continuous phase supply). In one particularly preferable aspect, there are included at least a first slit for second dispersion phase supply and a second slit for continuous phase supply or discharge. When there are provided the first dispersion phase supply slit (first liquid transfer port), second dispersion phase supply slit (first slit), a continuous phase supply or discharge slit (second liquid transfer port, second slit), and a discharge or continuous phase supply slit (third liquid transfer port), these slits are respectively constitute parts of the first dispersion phase supply port (first liquid transfer port), second dispersion phase supply port, continuous phase supply port or discharge port, and discharge port or continuous phase supply port (third liquid transfer port), and terminate at the connection sites with the plurality of microflow channels.

In the micro two-phase droplet generating device of the present invention, in a surface (in particular a flat plane) formed by the row of the plurality of microflow channels, the ends of the first liquid transfer port (first dispersion phase supply port), the first slit (second dispersion phase supply slit), the second liquid transfer port (continuous phase supply port or discharge port, preferably second slit), and the third liquid transfer port (discharge port or continuous phase supply port) are arranged in this order in the longitudinal direction of plurality of microflow channels. When the second liquid transfer port (second slit) constitutes a portion of the continuous phase supply port, the end of the discharge port follows the end of the second liquid transfer port (second slit), and when the second liquid transfer port (second slit) constitutes a portion of the discharge port, the end of the continuous phase supply port follows the end of the second liquid transfer port (second slit). As described above, the ends of the first dispersion phase supply port, and/or the discharge port and/or the continuous phase supply port serving as the second liquid transfer port and/or the third liquid transfer port may be slit(s) as described above.

The plurality of microflow channels are arranged so that the end of a slit is connected to an adjacent liquid transfer port or slit (liquid supply port or discharge port) on the slit-intersecting plane where the end of the slit is present (reference plane; in particular, the plane perpendicular to the slit).

### (Formation of Two-Phase Parallel Continuous Flow)

In the present invention, in the micro two-phase droplet generating device having the configuration described above, the first dispersion phase is supplied from the first liquid transfer port (first dispersion phase supply port) to the plurality of microflow channels, the second dispersion phase is supplied from the first slit (second dispersion phase supply slit) to the plurality of microflow channels, the first dispersion phase and the second dispersion phase join at the connection sites between the first slit (second dispersion phase supply slit) and the microflow channels and form two-phase parallel continuous flows, which are continuous flows containing two phases of the first dispersion phase and the second dispersion phase in parallel, in the microflow channels connecting the end of the first slit and the end of the second liquid transfer port (preferably the second slit). The formation of two-phase parallel continuous flows of the first dispersion phase and the second dispersion phase in the microflow channels connecting the end of the first slit and the end of the second liquid transfer port (preferably the second slit) is basically made possible by that the first dispersion phase and the second dispersion phase are not completely miscible with each other and one of the first dispersion phase and the second dispersion phase is not formed as a droplet in the other when they join, but it is preferable to adjust the flow velocity of the first dispersion phase and the second dispersion phase and the wettability of the first dispersion phase and the second dispersion phase relative to the walls of the microflow channels.

Two-phase parallel flow means that the two phases are separate in a cross-section of the flow, for example, they can be separated vertically or horizontally (the two phases can be freely oriented, the sizes of the two phases can be different, and the boundary line between the two phases can be a curve instead of a straight line), and alternatively, the inside and outside may be separated in the manner of concentric circles (though they are concentric circles, the outer phase may follow the cross-sectional shape of the microflow channel, and the inner phase may not be a perfect circle). When the two phases are separate, co-flow is also possible with one phase in the middle and the other in parallel on both sides thereof. The state where the two phases are separate is not limited to the state where the first dispersion phase and the second dispersion phase are not mixed at all, but parts of the first dispersion phase and the second dispersion phase may be mixed with each other, or at least one of them may be dissolved and diffused into the other, and the state where the two phases are separate is referred to the state that flows of two phases can be seen when the flow is observed in a macro scale.

Two-phase parallel continuous flow means that the two-phase parallel flow forms a continuous flow in the microflow channels connecting the end of the first slit (second dispersion phase supply slit) and the end of the second liquid transfer port. Though the two-phase parallel flow is formed near the connection site between the microflow channels, in which the first dispersion phase flows, and the first slit (second dispersion phase supply slit), and flows in the microflow channels, the two-phase parallel continuous flow particularly means a two-phase parallel flow up to the connection site between the microflow channels and the second liquid transfer port. In the present invention, the two-phase parallel continuous flow is a dispersion phase two-phase parallel continuous flow (two-dispersion phase parallel continuous flow).

### (Two-Phase Droplet Generation)

In the present invention, the continuous phase is supplied from the continuous phase supply port, which is either the second liquid transfer port or the third liquid transfer port, to the plurality of microflow channels. The second liquid transfer port is the continuous phase supply port or the discharge port, and when the second liquid transfer port is the continuous phase supply port, the third liquid transfer port is a discharge port, and when the second liquid transfer port is the discharge port, the third liquid transfer port is a continuous phase supply port.

In this case, at the connection site (temporarily referred to as connection site X) between the microflow channel and the second liquid transfer port, the first slit is on one side of the microflow channel and the third liquid transfer port is on the other side. At connection site X, the two-dispersion phase parallel continuous flow described above is supplied from the microflow channel on the side of the first slit (temporarily referred to as microflow channel A), and a continuous phase is supplied from the second liquid transfer port or from the microflow channel (temporarily referred to as microflow channel B) on the side of the third liquid transfer port, whereby the two-dispersion phase parallel continuous flow and continuous phase join. At connection site X, in particular when the third liquid transfer port is the second slit, the dispersion phase two-phase parallel continuous flow is sheared by the continuous phase flow as a driving force, whereby two-phase droplets such as core-shell or Janus droplets are generated in the second liquid transfer port or the microflow channel B by the first dispersion phase and the second dispersion phase. Whether the generated two-phase droplet is core-shell, Janus, or another type, and in the case of core-shell droplets, whether the first dispersion phase or the second dispersion phase is the core or the shell, are determined basically by the interfacial tension relationship between the first dispersion phase, the second dispersion phase, and the continuous phase.

The product containing the two-phase droplets such as core-shell or Janus droplets is discharged from the discharge port and collected. When the second liquid transfer port is the continuous phase supply port, the discharge port is connected to microflow channel B, and when the microflow channel B is connected to the continuous phase supply port, the second liquid transfer port is the discharge port.

The second liquid transfer port constitutes a part of the continuous phase supply port or discharge port as described above, and at the same time, at the connection site X with microflow channels A and B on both sides, is an element which also has the function of generating two-phase droplets such as core-shell or Janus droplets of the dispersion phases from the dispersion phase two-phase parallel continuous flow and the continuous phase.

In the micro two-phase droplet generating device of the present invention, the liquid transfer ports (first dispersion phase supply port, continuous phase supply port, discharge port) other than the first slit may have slits at their ends connected to the microflow channels. Thus, though the micro two-phase droplet generating device of the present invention has at least one slit, the number of slits may be two or more. For example, the end of the first dispersion phase supply port, which is the first liquid transfer port, the end of the continuous phase supply port or discharge port, which is the second liquid transfer port, and the end of the continuous phase supply port or discharge port, which is the third liquid transfer port, can optionally be slits. However, the ends of the first liquid transfer port, the second liquid transfer port, and the third liquid transfer port need not be slits, and may optionally be cylindrical pores or the like. Each of the ends of the first liquid transfer port, the second liquid transfer port, and the third liquid transfer port should be able to supply the liquid to each of the pluralities of microflow channels or discharge the liquid, and though the number of the ends is not limited, it is structurally simple and preferable that each microflow channel have one.

The first dispersion phase and the second dispersion phase may be a combination capable of forming a two-phase parallel continuous flow without being completely mixed with each other, and they may be partially mixed, dissolved or diffused with each other.

The first dispersion phase and the second dispersion phase join a continuous phase after forming a two-phase parallel continuous flow to generate two-phase droplets, and a combination with a continuous phase capable of generating two-phase droplets later is selected.

### (Dispersion phase/Continuous Phase)

In the present invention, the liquid forming the dispersion phase or continuous phase is preferably an organic compound or water. Though the organic compound is not particularly limited, preferable examples thereof include fluorine-based oils, silicone oils, alkanes such as decane and octane, liquid paraffin, halogenated hydrocarbons such as chloroform, aromatic hydrocarbons such as toluene, and fatty acids such as oleic acid. Furthermore, to obtain solid or gel-like microparticles, an aqueous phase or an organic phase which can be cured by cross-linking by heat, photopolymerization reaction, or ion exchange reaction can be used as the dispersion phase, and, for example, a known polymerizable monomer, oligomer, or polymer, preferably, acrylate-based monomer or styrene-based monomer can be used as a material.

The dispersion phase may be either an organic phase or an aqueous phase, and the two-phase dispersion phase combination may be organic phase/aqueous phase, aqueous phase/organic phase, or organic phase/organic phase.

Furthermore, the continuous phase may be either an organic phase or an aqueous phase.

As the combination of the two-phase dispersion phase and the continuous phase, preferably, when the continuous phase is an organic phase, the two-phase dispersion phase can be aqueous phase/organic phase, organic phase/organic phase, or organic phase/aqueous phase, and when the continuous phase is an aqueous phase, the two-phase dispersion phase can be aqueous phase/organic phase or organic phase/organic phase. Examples of preferable two-phase dispersed and continuous phase combinations include (organic phase/organic phase)/aqueous phase, (aqueous phase/organic phase)/aqueous phase. Specific examples include combinations of (acrylate-based monomer/silicone oil)/water and (water/alkanes)/water.

In order to generate micro two-phase droplets such as core-shell or Janus droplets in the continuous phase, it is preferable that the interfacial tension between the continuous phase and the two-phase dispersion phase have a predetermined relationship.

Though not to be bound by theory, it is believed that when the first dispersion phase is defined as phase 1, the continuous phase is defined as phase 2, and the second dispersion phase is defined as phase 3, the interfacial tension between phases 1 and 2 is denoted as γ₁₂, the interfacial tension between phases 1 and 3 is denoted as γ₁₃, and the interfacial tension between phases 2 and 3 is denoted as γ₂₃, when γ₁₂ > γ₂₃, between the spreading parameter S defined by Si = γⱼₖ - (γᵢⱼ + γₖᵢ) [where i, j and k are one of 1, 2 and 3 and different from each other], (i) when S₁ < 0, S₂ < 0, S₃ > 0, core-shell (complete encapsulation) droplets are generated, (ii) when S₁ < 0, S₂ < 0, S₃ < 0, Janus (partial encapsulation) droplets are generated, and (iii) when S₁ < 0, S₂ > 0, S₃ < 0, nonencapsulated droplets (phase 1 and phase 3 generate separate droplets) are generated. However, the interfacial tension (measured value) of the dispersion phase and the continuous phase used is not necessarily maintained during the droplet generation process, depending on the equipment and process conditions, and the interfacial tension (measured value) may not establish the droplet type in accordance with the above relational expressions. Furthermore, the interfacial tension between the continuous phase and the wall surface of the microflow channel or slit also affects the flow.

Thus, it is sometimes preferable that for example, when the continuous phase is an aqueous phase, a wall surface of the channel or path through which the continuous phase flows, and in particular, a wall surface of the path in which the two-phase droplets are generated and flow, be subjected to a hydrophilic treatment, or when the continuous phase is an organic phase, a wall surface of the channel or path in which the continuous phase flows, and in particular, a wall surface of the channel or path in which the two-phase droplets are generated and flow, be subjected to a hydrophobic treatment. Channel or path wall surfaces are generally hydrophobic when they are composed of an organic resin and hydrophilic when they are composed of metal or glass. As the hydrophilic treatment, for example, a coating treatment with a hydrophilic polymer or a plasma irradiation treatment can be used. As the hydrophobic treatment, a coating treatment with a hydrophobic polymer can be used.

In one preferred aspect, in order to generate core-shell microdroplets having an aqueous phase as the core and an organic phase as the shell, inner walls of the microflow channels (16) connecting the end of the first slit (12) and the end of the second liquid transfer port (13) may be composed of hydrophobic surfaces, inner walls of the microflow channels (16) connecting the end of the second liquid transfer port (13) and the end of the third liquid transfer port (14) may be composed of hydrophilic surfaces, the first dispersion phase (1) may be an aqueous phase, the second dispersion phase (2) may be an organic phase, the continuous phase (3) may be an aqueous phase, and the continuous phase (3) may be supplied from the second liquid transfer port (13) to the microflow channels (16).

Likewise, in one preferred aspect, inner walls of the microflow channels (16) connecting the end of the first slit (12) and the end of the second liquid transfer port (13) may be composed of hydrophobic surfaces, an inner wall of the second liquid transfer port (13) may be composed of a hydrophilic surface, the first dispersion phase (1) may be an aqueous phase, the second dispersion phase (2) may be an organic phase, the continuous phase (3) may be an aqueous phase, and the continuous phase (3) may be suppled from the third liquid transfer port (14) to the microflow channels (16) to generate core-shell microdroplets having an aqueous phase as the core and an organic phase as the shell.

In another preferred aspect, in order to generate microdroplets composed of two organic phases which have separate phases from each other such as Janus or core-shell droplets, inner walls of the microflow channels (16) may be composed of hydrophilic surfaces, the first dispersion phase (1) may be an organic phase, the second dispersion phase (2) may be an organic phase, and the continuous phase (3) may be an aqueous phase, and the continuous phase (3) may be supplied from the second liquid transfer port (13) to the microflow channels (16).

Likewise, in one preferred aspect, an inner wall of the second liquid transfer port (13) may be composed of a hydrophilic surface, the first dispersion phase (1) may be an organic phase, the second dispersion phase (2) may be an organic phase, the continuous phase (3) may be an aqueous phase, and the continuous phase (3) may be supplied from the third liquid transfer port (14) to the microflow channels (16) to generate Janus or core-shell microdroplets composed of two organic phases having separate phases.

Furthermore, a surfactant can be added to each liquid in order to adjust the interfacial tension between the dispersion phase 1, the dispersion phase 2, and the continuous phase.

The flow rates of the first dispersion phase, the second dispersion phase, and the continuous phase per single microflow channel are, depending on the type thereof, usually about 0.001 mL to 100 mL/hour, preferably about 0.01 mL to 10 mL/hour, and more preferably about 0.1 mL to 5 mL/hour. The flow rates of the first and second dispersion phases control the ratio of the two-phase dispersion phase in the generated two-phase (core-shell, Janus, etc.) droplets, and they may be selected from, for example, about 1: 1000 to 1000: 1, about 1:100 to 100:1, or about 10:100 to 100:10.

The ratio of the total flow rate of the first dispersion phase and the second dispersion phase (flow rate of two-phase parallel continuous flow) to the flow rate of the continuous phase may be selected from, for example, between about 1:100 and 100:1, between about 2:100 and 100:2, and further, between about 5:100 and 100:5, but for the purpose of shearing the two-phase parallel continuous flow by the continuous phase flow to generate two-phase droplets having excellent size uniformity, the flow rate is preferably set so that the Reynolds number is sufficiently small (< 10³), whereby the two-phase parallel continuous flow and the continuous phase flow each form a laminar flow. Though depending significantly on the properties of liquids used, if the dispersion phase flow rate is excessively high relative to the continuous phase flow rate, or conversely, if the continuous phase flow rate is excessively high relative to the dispersion phase flow rate, since the two-phase droplets are not sheared near the confluence of the two, the two-phase parallel continuous flow continues to downstream, or the droplets are generated irregularly, and thus, it is preferable to adjust the flow rate appropriately so that two-phase droplets are generated near the second liquid transfer port.

### (Examples of Embodiments)

Examples of preferred embodiments of the present invention will be described below with reference to the drawings, but the present invention is not limited to these embodiments, and it should be noted that the shape and dimensions of each embodiment are not limited and can be appropriately changed.

### (Embodiment 1)

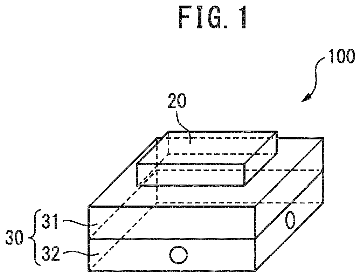

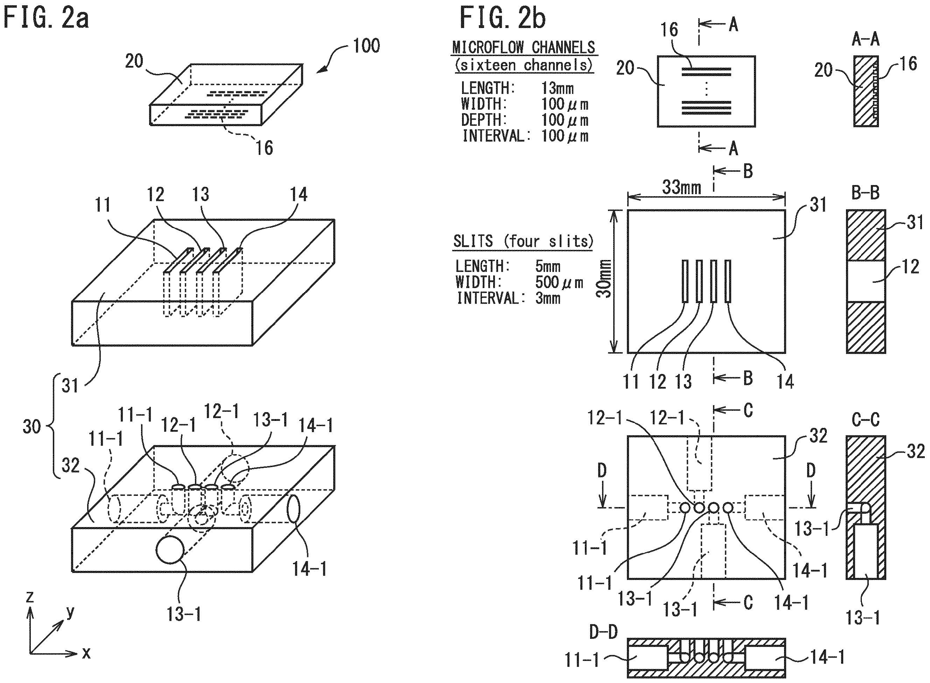

An example of a micro two-phase droplet generating device (100) according to an embodiment of the present invention is shown in FIGS. 1, 2a and 2b. In FIG. 1, the micro two-phase droplet generating device (100) comprises, in order from above, a microgroove array substrate (also referred to as a microflow channel array) (20), a first member (31) and a second member (32) of a liquid distributing part (30). The microgroove array substrate (20) has, for example, dimensions of a width of 20 mm, a length of 25 mm, and a height of 4 mm. The first member (31) and the second member (32) each have dimensions of, for example, a width of 30 mm, a length of 33 mm, and a height of 8 mm. The part and members are aligned with each other and liquid-tightly coupled to each other by fastening structures such as bolts.

FIG. 2a is an exploded perspective view of the micro two-phase droplet generating device (100), and shows, in order from above, the microgroove array substrate (20) and the first member (31) and the second member (32) of the liquid distributing part (30). FIG. 2b shows a plan view, and cross-sectional views taken from the right and below the plan view of the microgroove array substrate (20) and the first member (31) and the second member (32) of the liquid distributing part (30) of the micro two-phase droplet generating device (100). The cross-sectional views are taken along line segments AA, BB, CC, and DD in the plan view in order from the top of the drawing. The fastening structures are omitted in the attached drawings.

Referring to FIG. 2a, the microgroove array substrate (20) has a row of microchannels (16) on the lower surface facing the liquid distributing part (30). The row of microchannels (16) is composed of 16 linear microgrooves (16) arranged in parallel, and specifically, has linear microgrooves (16) having a length of 13 mm and a rectangular cross-section (width 100 µm, height 100 µm), and the interval between adjacent grooves is 100 µm. When the microgroove array substrate (20) and the first member (31) of the liquid distributing part (30) are liquid-tightly coupled, the top surface of the microgrooves (16-1) formed in the microgroove array substrate (20) is enclosed by the top surface of the first member (31) to form microflow channels (16).

The first member (31) of the liquid distributing part (30) comprises four slits including, in order from the left in FIGS. 2a and 2b, a slit (11) for the first dispersion phase supply, a slit (12) for the second dispersion phase supply, a slit (13) for the continuous phase supply, and a slit (14) for product discharge. In the definitions of the present invention, the second dispersion phase supply slit (12) is the first slit, and the continuous phase supply slit (13) is the second slit as a preferred example of the second liquid transfer port. Each slit has a slit end (opening) having a longitudinal width (length) of 5 mm and a short lateral width (width) of 500 µm on the main surface of the first member (31), and the interval between the slits is 3 mm. Each slit forms a space (three-dimensional slit) in the shape of a flat plate (hereinafter also simply referred to as a plate shape) penetrating the first member (31) in the thickness direction. In the present invention, the first slit (12) is indispensable, but the first dispersion phase supply slit (11), the continuous phase supply slit (13), and the product discharge slit (14) need not be slits, the first dispersion phase supply port, the continuous phase supply port, and the product discharge port (all liquid transfer ports) are sufficient, and they may be, for example, large holes which terminate and are open on the main surface of the first member (31) and which are connected to the plurality of microflow channels (16).

The longitudinal direction of the row of microchannels (16) of the microgroove array substrate (20) and the longitudinal direction of the slits (11, 12, 13, 14) of the first member (31) are arranged as to be orthogonal to each other.

The second member (32) at the bottom of the liquid distributing part (30) comprises a first dispersion phase supply port (11-1), a second dispersion phase supply port (12-1), a continuous phase supply port (13-1), a product discharge port (14-1), and these are respectively in fluid connection with the first dispersion phase supply slit (11), the second dispersion phase supply slit (12), the continuous phase supply slit (13), and the product discharge slit (14). The first dispersion phase supply port (11-1), the second dispersion phase supply port (12-1), the continuous phase supply port (13-1), and the product discharge port (14-1) have cylindrical longitudinal holes on top surfaces thereof at positions coincident with the ends of the corresponding slits and are spatially continuous with the cylindrical transverse holes extending to the four side surfaces of the second member (32). The cylindrical transverse holes which open on the four sides of the second member (32) may have internal threads for liquid-tight connection with an external liquid supply or liquid discharge member.

The first dispersion phase supply slit (11), the second dispersion phase supply slit (12), the continuous phase supply slit (13), and the product discharge slit (14) functionally serve as extensions or ends of the first dispersion phase supply port (11-1), the second dispersion phase supply port (12-1), the continuous phase supply port (13-1), and the product discharge port (14-1), respectively, and constitute portions of the first dispersion phase supply port (11-1), the second dispersion phase supply port (12-1), the continuous phase supply port (13-1), and the product discharge port (14-1), respectively. In the present invention, the first dispersion phase supply slit (11), the second dispersion phase supply slit (12), the continuous phase supply slit (13), and the product discharge slit (14) are included in the first dispersion phase supply port (11-1), the second dispersion phase supply port (12-1), the continuous phase supply port (13-1), and the product discharge port (14-1). In the following embodiments, depending on the drawing or context, those without the first dispersion phase supply slit (11), the second dispersion phase supply slit (12), the continuous phase supply slit (13), and the product discharge slit (14) are sometimes designated or referred to as the first dispersion phase supply port (11-1), the second dispersion phase supply port (12-1), the continuous phase supply port (13-1), and the product discharge port (14-1) in a narrower notion.

In embodiment 1, the plurality of microflow channels (16) are each supplied with the first dispersion phase (1) from the first dispersion phase supply slit (11) and the second dispersion phase (2) from the second dispersion phase supply slit (12), and as described below, the two-phase parallel continuous flows (4) are formed in the microflow channels (16) between the first slit (12) and the second slit (13), the continuous phase (3) is supplied from the continuous phase supply slit (13), two-phase droplets (5) such as core-shell or Janus droplets are generated near the connection sites of the microflow channels (16) with the second slit (13), and the two-phase droplets (5) are discharged through the product discharge slit (14) and the product discharge port (14-1).

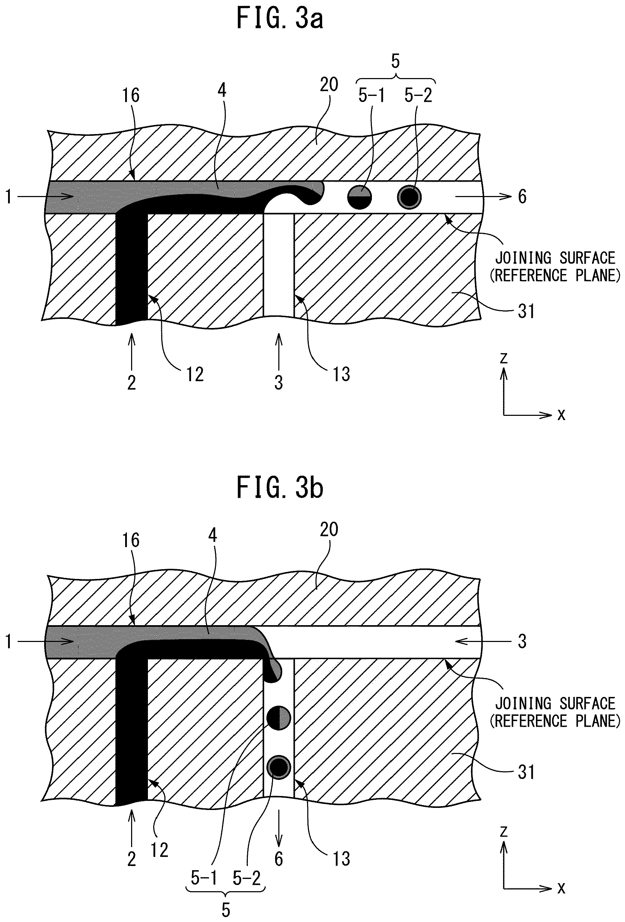

FIG. 3a is a partial schematic view of a longitudinal section of the micro two-phase droplet generating device (100) of FIGS. 2a and 2b taken along the longitudinal direction of one microflow channel (16), and schematically shows an aspect in which two-phase droplets are generated. In FIG. 3a, a microflow channel (16) is formed above the joining surface (reference plane) of the microgroove array substrate (20) with the liquid distributing part (30), and the slits (12, 13) extend vertically downward from the joining surface (reference plane).

When the microflow channel (16) is supplied with the first dispersion phase (1) from the left in FIG. 3a to the microflow channel (16) to form the flow of the first dispersion phase (1) and the second dispersion phase (2) from the first slit (12) to form the flow of the second dispersion phase (2), the flow of the first dispersion phase (1) and the flow of the second dispersion phase (2) join at the connection site of the microflow channel (16) and the first slit (12), whereby the two-phase parallel continuous flow (4) of the first dispersion phase (1) and the second dispersion phase (2) is formed in the microflow channel (16) between the first slit (12) and the second slit (13). The two-phase parallel continuous flow (4) means that the two phases of the first dispersion phase (1) and the second dispersion phase (2) do not completely mix with each other and form separate continuous flows. The two-phase parallel continuous flow (4) has a two-phase structure in which the two phases of the first dispersion phase (1) and the second dispersion phase are not completely mixed and are separate in the cross section of the microflow channel (16).

When the continuous phase (3) is supplied from the continuous phase supply slit (13) to the plurality of microflow channels (16), the flow of the two-phase parallel continuous flow (4) is sheared by the flow of the continuous phase (3) as a driving force near the connection site of the microflow channels (16) with the slit (13) for continuous phase supply, whereby the two phases of the first dispersion phase (1) and the second dispersion phase (2) generate two-phase droplets (5) having a core-shell or Janus structure. In FIG. 3a, two types of two-phase droplets, a core-shell droplet (5-2) and a Janus droplet (5-1), are drawn for explanation, but in reality, one type of two-phase droplets (5) such as core-shell droplets (5-2) or Janus droplets (5-1) are generated. Whether the two-phase droplets (5) will be core-shell droplets (5-2) or Janus droplets (5-1) and which of the first dispersion phase (1) and the second dispersion phase (2) becomes the core or the shell when core-shell droplets (5-2) are generated are primarily determined from the mutual interfacial tensions of the first dispersion phase (1), the second dispersion phase (2), and the continuous phase (3). Furthermore, in FIG. 3a, the core-shell droplet (5-2) is shown as a core-shell droplet (5-2) having the second dispersion phase (2) as the core and the first dispersion phase (1) as the shell, but the first dispersion phase (1) may be the core and the second dispersion phase (2) may be the shell.

The product containing the two-phase droplets (5) is discharged through the product discharge slit (14) and the product discharge port (14-1).

### (Embodiment 2)

The micro two-phase droplet generating device (100) of embodiment 2 of the present invention is similar to the micro two-phase droplet generating device (100) of embodiment 1, but the continuous phase supply slit and the product discharge slit of embodiment 1 are switched, and the continuous phase supply port and the product discharge port are switched. As a result, in FIGS. 2a and 2b, the slit (13) is the product discharge slit, the slit (14) is the continuous phase supply slit, the liquid transfer port (13-1) is the product discharge port, and the liquid transfer port (14-1) is the continuous phase supply port.

In embodiment 2, the plurality of microflow channels (16) are each supplied with the first dispersion phase (1) from the first dispersion phase supply slit (11) and the second dispersion phase (2) from the second dispersion phase supply slit (12), as described below, the two-phase parallel continuous flows (4) are formed in the microflow channels (16) between the first slit (12) and the second slit (13), the continuous phase (3) is supplied from continuous phase supply slit (14), two-phase droplets (5-1, 5-2) such as core-shell or Janus droplets are generated near the connection site of the microflow channel (16) with the second slit (13), and the two-phase droplets (5-1, 5-2) are discharged through the product discharge slit (13) and the product discharge port (13-1).

FIG. 3b is a partial schematic view of a transverse cross-section which cuts the micro two-phase droplet generating device (100) of embodiment 2 along the longitudinal direction of one microflow channel (16), and schematically shows an aspect in which two-phase droplets are generated. In FIG. 3b, the microflow channel (16) is formed above the joining surface (reference plane) of the microgroove array substrate (20) with the first member (31) of the liquid distributing part (30), and slits (12, 13) extend vertically downward from the joining surface (reference plane).

When the plurality of microflow channels (16) are supplied, in FIG. 3b, with the first dispersion phase (1) from the left to form the flow of the first dispersion phase (1) and the second dispersion phase (2) from the first slit (12) to form the flow of the second dispersion phase (2), the flow of the first dispersion phase (1) and the flow of the second dispersion phase (2) join at the connection site of the microflow channel (16) and the first slit (12), whereby the two-phase parallel continuous flow (4) of the first dispersion phase (1) and the second dispersion phase (2) is formed in the microflow channel (16) between the first slit (12) and the second slit (13).

When the continuous phase (3) is supplied from the continuous phase supply slit (14) to the plurality of microflow channels (16), the two-phase parallel continuous flow (4) is sheared by the flow of the continuous phase (3) as a driving force near the connection site of the product discharge slit (13) with the microflow channel (16), whereby the two phases of the first dispersion phase (1) and the second dispersion phase (2) can generate two-phase droplets (5) having a core-shell type or Janus type structure. In FIG. 3b, two types of two-phase droplets, a core-shell droplet (5-2) and a Janus droplet (5-1), are drawn for explanation, but in reality, one type of two-phase droplets (5) such as core-shell droplets (5-2) or Janus droplets (5-1) are generated. Furthermore, in FIG. 3b, a core-shell droplet (5-2) having the second dispersion phase (2) as the core and the second dispersion phase (1) as the shell is shown, but it may be a core-shell droplet having the second dispersion phase (1) as the core and the second dispersion phase (2) as the shell.

The product containing the two-phase droplets (5) is discharged through the product discharge slit (13) and the product discharge port (13-1).

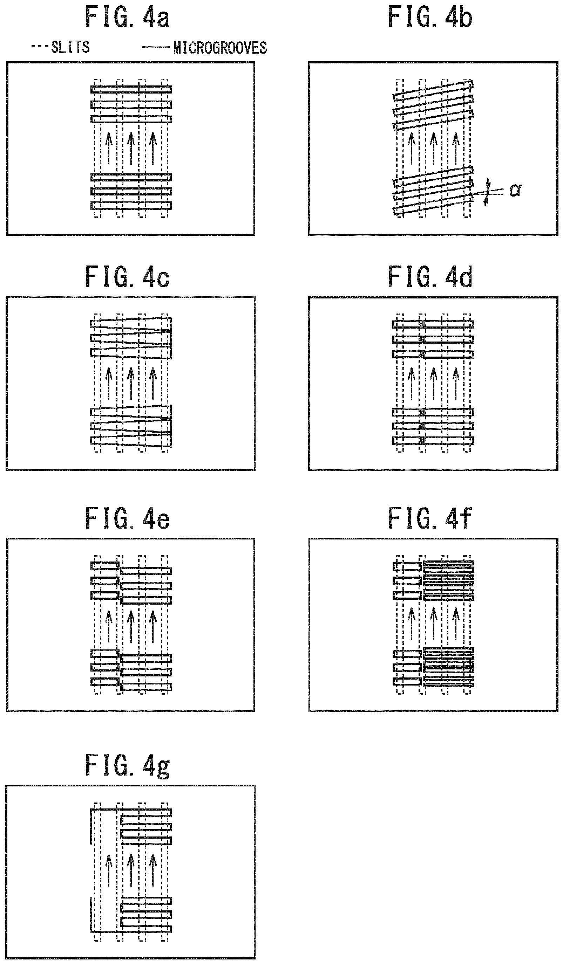

FIG. 4 shows examples of the groove shape of the part (20) having the microgrooves (16) joined to the liquid distributing part (30) in embodiments 1 and 2 of the present invention. FIG. 4a shows the case where four slits (dashed lines) are vertically bridged by a row of linear microflow channels (solid lines), FIG. 4b shows the case where four slits (dashed lines) are bridged so as to intersect diagonally with a row of linear microflow channels (solid lines), and FIG. 4c shows the case where the widths of the microflow channels (solid lines) bridging the four slits continuously change. Note that the widths of the microgrooves may change discontinuously. FIGS. 4d to 4f show the cases where the microflow channels (solid line) connecting the interposed slits (dashed line) and the slits (dashed line) on both sides are divided, FIG. 4d shows the case when the positions and sizes thereof match, FIG. 4e shows when the positions are misaligned, and FIG. 4f shows the case where the numerical correspondence is not 1:1. FIG. 4g shows the case where the rows of bridging microflow channels (solid lines) are partially joined to each other. The features of FIGS. 4a to 4g may be arbitrarily combined.

In embodiments 1 and 2 of the present invention, the microgroove array substrate (20) can be produced, for example, by transferring a pattern from a mold produced using a negative photoresist SU-8 (Nippon Kayaku Co., Ltd.) onto a Si substrate to a silicone resin (PDMS: polydimethylsiloxane). The liquid distributing part (20) can be produced, for example, by machining a stainless-steel material (SUS304). The slit-like through-holes of the liquid distributing part (20) can be produced by, for example, wire electrical discharge machining.

In embodiments 1 and 2 of the present invention, for example, by feeding a first dispersion phase such as silicone oil (SO), a second dispersion phase such as 1,6-hexanediol diacrylate (HDDA), and a continuous phase such as a polyvinyl alcohol (PVA) aqueous solution, core-shell two-phase droplets can be generated. Furthermore, by feeding a first dispersion phase such as 1,6-hexanediol diacrylate (HDDA), a second dispersion phase such as silicone oil to which 1 wt% of a surfactant has been added (SO + surfactant), and a continuous phase such as a polyvinyl alcohol (PVA) aqueous solution, Janus two-phase droplets can be generated. For example, a glass syringe and a syringe pump can be used to feed the dispersion phase and the continuous phase. For observing droplet generation and measuring the sizes of the generated droplets, it is suitable to use, for example, an upright optical microscope and a high-speed video camera in combination.

### (Embodiment 3)

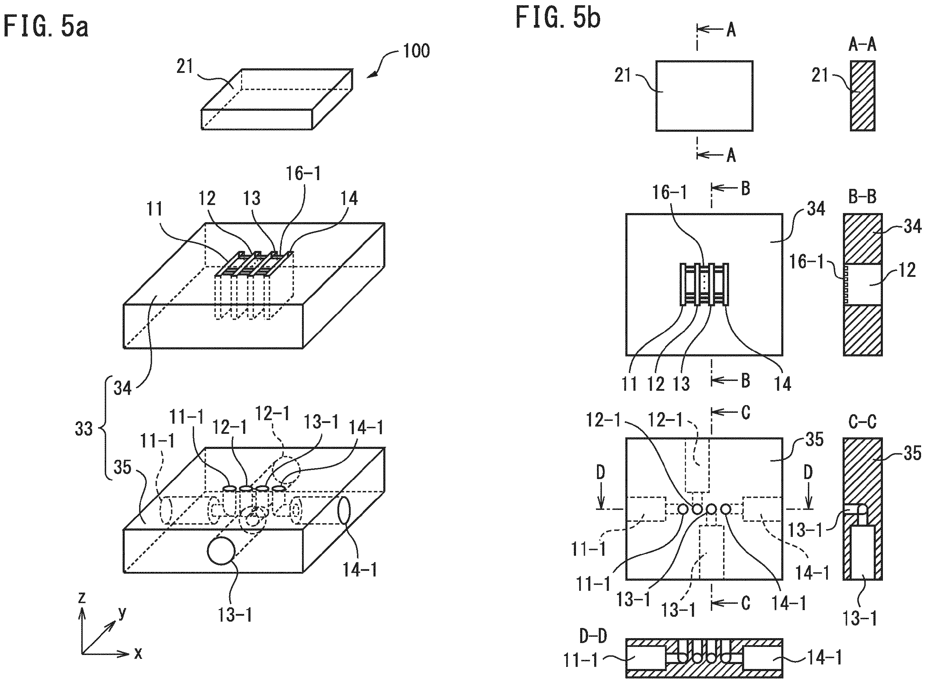

As shown in FIGS. 5a and 5b, the micro two-phase droplet generating device (100) of embodiment 3 comprises, in order from above, the microgroove sealing cover (21) and a first member (34) and a second member (35) of the liquid distributing part (33). The sealing cover (21) has dimensions of, for example, a width of 20 mm, a length of 20 mm, and a height of 4 mm. The first member (34) and the second member (35) each have dimensions of, for example, a width of 30 mm, a length of 33 mm, and a height of 8 mm. These parts and members are aligned with each other and fluid-tightly coupled to each other by fastening structures such as bolts. The fastening structures are omitted from the drawings.

FIG. 5a is an exploded perspective view of the micro two-phase droplet generating device (100), and includes, in order from the top, the sealing cover (21) and the first member (34) and the second member (35) of the liquid distributing part (33). FIG. 5b shows a plan view of the sealing cover (21) and the first member (34) and the second member (35) of the liquid distributing part (33) of the micro two-phase droplet generating device (100), and shows cross-sectional views to the right and below the plan view. The cross-sectional views are taken along the line segments AA, BB, CC, and DD in the plan view in order from the top of the drawing.

With reference to FIGS. 5a and 5b, the sealing cover (21) has a flat surface with no microchannels on the lower surface facing the liquid distributing part (33).

The first member (34) of the liquid distributing part (33) comprises four slits including, in order from the left of FIGS. 5a and 5b, the first dispersion phase supply slit (11), the second dispersion phase supply slit (12), the continuous phase supply slit (13), and the product discharge slit (14). In the definitions of the present invention, the second dispersion phase supply slit (12) is the first slit, and the continuous phase supply slit (13) is the second slit as a preferred example of the continuous phase supply liquid transfer port. Each slit has a slit end (opening) having a longitudinal width (length) of 5 mm and a short lateral width (width) of 500 µm on the main surface of the first member (34), and the interval between the slits is 3 mm. Each slit forms a platelike space (three-dimensional slit) penetrating the first member (34) in the thickness direction.

The first member (34) of the liquid distributing part (33) has a total of 16 linear microgrooves (16-1) each having a rectangular cross section (width 100 µm, depth 100 µm) and extending from the first dispersion phase supply slit (11) to the product discharge slit (14) over each spacing among the first dispersion phase supply slit (11), the second dispersion phase supply slit (12), the continuous phase supply slit (13), and the product discharge slit (14), and sections of each of the 16 linear microgrooves (16-1) are formed on a straight line over the second dispersion phase supply slit (12) and the continuous phase supply slit (13). The longitudinal direction of the row of microchannels (16-1) and the longitudinal direction of the slits (11, 12, 13, 14) of the first member (34) perpendicularly cross each other.

When the sealing cover (21) is liquid-tightly coupled to the top surface of the first member (34) formed with the microgrooves (16-1) of the liquid distributing part (33), the microgrooves (16-1) are closed to form the microflow channels (16-1).

In the present invention, the first slit is indispensable, but the first dispersion phase supply slit (11), the continuous phase supply slit (13), and the product discharge slit (14) need not be slits, and it is sufficient that they be the first dispersion phase supply port, the continuous phase supply port, and the product discharge port (liquid transfer ports), and for example, they may be large holes connected to the plurality of microflow channels (16-1) formed on the main surface of the first member (34).

The lower second member (35) of the liquid distributing part (33) comprises the first dispersion phase supply port (11-1), the second dispersion phase supply port (12-1), the continuous phase supply port (13-1), and the product discharge port (14-1), which are fluidly connected, respectively, to the first dispersion phase supply slit (11), the second dispersion phase supply slit (12), the continuous phase supply slit (13), and the product discharge slit (14). The first dispersion phase supply port (11-1), the second dispersion phase supply port (12-1), the continuous phase supply port (13-1), and the product discharge port (14-1) have cylindrical longitudinal holes on top surfaces thereof at positions coincident with the ends of the corresponding slits and are spatially continuous with the cylindrical transverse holes extending to the four side surfaces of the second member (35). The cylindrical transverse holes which open on the four sides of the second member (35) may have internal threads for liquid-tight connection with an external liquid supply or liquid discharge member.

The first dispersion phase supply slit (11), the second dispersion phase supply slit (12), the continuous phase supply slit (13), and the product discharge slit (14) functionally serve as extensions or ends of the first dispersion phase supply port (11-1), the second dispersion phase supply port (12-1), the continuous phase supply port (13-1), and the product discharge port (14-1), respectively, and constitute parts of the first dispersion phase supply port (11-1), the second dispersion phase supply port (12-1), the continuous phase supply port (13-1), and the product discharge port (14-1), respectively. In the definitions of the present invention, the first dispersion phase supply slit (11), the second dispersion phase supply slit (12), the continuous phase supply slit (13), and the product discharge slit (14) are included in the first dispersion phase supply port (11-1), the second dispersion phase supply port (12-1), the continuous phase supply port (13-1), and the product discharge port (14-1). In the following embodiments, depending on the drawing or context, those without the first dispersion phase supply slit (11), the second dispersion phase supply slit (12), the continuous phase supply slit (13), and the product discharge slit (14) are sometimes designated or referred to as the first dispersion phase supply port (11-1), the second dispersion phase supply port (12-1), the continuous phase supply port (13-1), and the product discharge port (14-1) in a narrower notion.

In embodiment 3, the microflow channels (16-1) are each supplied with the first dispersion phase (1) from the first dispersion phase supply slit (11) and the second dispersion phase (2) from the second dispersion phase supply slit (12), and as described below, the two-phase parallel continuous flow (4) is formed in the microflow channel (16-1) between the first slit (12) and the second slit (13), the continuous phase (3) is supplied from continuous phase supply slit (13), the two-phase droplets (5-1, 5-2) such as core-shell or Janus droplets are generated near the connection sites of the microflow channels (16-1) with the second slit (13), and the two-phase droplets (5-1, 5-2) are discharged through the product discharge slit (14) and the product discharge port (14-1).

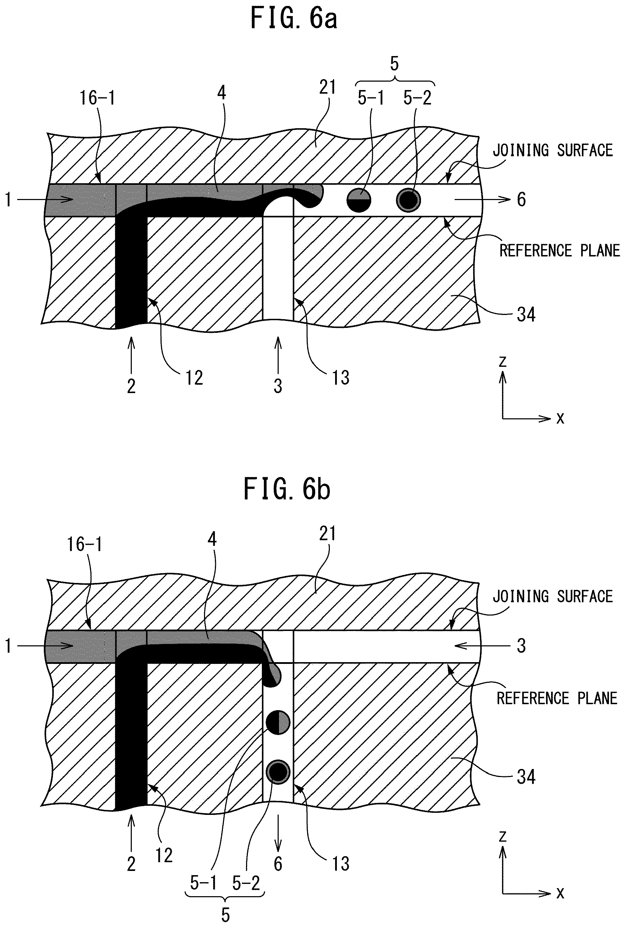

FIG. 6a is a partial schematic view of a longitudinal cross-section of the micro two-phase droplet generating device (100) taken along the longitudinal direction of one microflow channel (16-1), and schematically shows an aspect in which two-phase droplets (5) are generated. In FIG. 6a, the microflow channel (16-1) based on microgrooves is formed in the downward direction of the joining surface between the sealing cover (21) and the liquid distributing part (33), and the slits (12, 13) extend vertically downward from the reference plane with the microflow channel (16-1), i.e., the plane connecting the bottom (lower surface) of the microgroove (16-1), serving as the reference plane.

When the plurality of microflow channels (16-1) are supplied with the first dispersion phase (1) from the left in FIG. 6a to form the flow of the first dispersion phase (1) and the second dispersion phase (2) from the first slit (12) to form the flow of the second dispersion phase (2), the flow of the first dispersion phase (1) and the flow of the second dispersion phase (2) join at the connection site between the microflow channel (16-1) and the first slit (12), and the two-phase parallel continuous flow (4) of the first dispersion phase (1) and the second dispersion phase (2) is formed in the microflow channel (16-1) between the first slit (12) and the second slit (13).

When the continuous phase (3) is supplied from the continuous phase supply slit (13) to the plurality of microflow channels (16-1), the flow of the two-phase parallel continuous flow (4) is sheared by the flow of the continuous phase (3) as a driving force near the connection site of the microflow channel (16-1) with the continuous phase supply slit (13), whereby the two-phase droplet (5) having a core-shell or Janus structure can be generated from the two phases of the first dispersion phase (1) and the second dispersion phase (2). In FIG. 6a, two types of two-phase droplets, a core-shell droplet (5-2) and a Janus droplet (5-1), are drawn for explanation, but in reality one type of two-phase droplets (5) such as core-shell droplets (5-2) or Janus droplets (5-1) are generated. In FIG. 6a, the core-shell droplet (5-2) having the second dispersion phase (2) as the core and the first dispersion phase (1) as the shell is shown, but it may be a core-shell droplet having the first dispersion phase (1) as the core and the second dispersion phase (2) as the shell.

The product containing the two-phase droplets (5) is discharged through the product discharge slit (14) and the product discharge port (14-1).

### (Embodiment 4)

The micro two-phase droplet generating device (100) of embodiment 4 is similar to the micro two-phase droplet generating device (100) of embodiment 3, but differs in that the continuous phase supply slit and the product discharge slit of embodiment 1 are exchanged with each other, and the continuous phase supply port (13-1) and the product discharge port are exchanged. As a result, in FIGS. 5a and 5b, slit (13) is the product discharge slit, the slit (14) is the continuous phase supply slit, the liquid transfer port (13-1) is the product discharge port, and the liquid transfer port (14-1) is the continuous phase supply port.

In embodiment 4, the microflow channel (16-1) is supplied with the first dispersion phase (1) from the first dispersion phase supply slit (11) and the second dispersion phase (2) from the second dispersion phase supply slit (12), and as described below, the two-phase parallel continuous flow (4) is formed in the microflow channel (16-1) between the first slit (12) and the second slit (13), the continuous phase (3) is supplied from the continuous phase supply port (14-1) and the continuous phase supply slit (14), the two-phase droplets (5-1, 5-2) such as core-shell or Janus droplets are generated near the connection site of the microflow channel (16-1) with the second slit (13), and the two-phase droplets (5-1, 5-2) are discharged through the product discharge slit (13) and the product discharge port (13-1).

FIG. 6) is a partial schematic view of a longitudinal cross-section of the micro two-phase droplet generating device (100) of the embodiment 4 taken along the longitudinal direction of one microflow channel (16-1), and schematically shows an aspect in which two-phase droplets are generated. In FIG. 6b, the microflow channel (16-1) based on microgroove is formed in the downward direction of the joining surface between the sealing cover (21) and the first member (34) of the liquid distributing part (33), and the slits (12, 13) extend vertically downward from the reference plane with the microflow channel (16-1), i.e., the virtual plane connecting the bottom (lower surface) of the microgrooves serving as the reference plane.

When the microflow channel (16-1) is supplied with the first dispersion phase (1) from the left in FIG. 6b to form the flow of the first dispersion phase (1) and the second dispersion phase (2) from the first slit (12) to form the flow of the second dispersion phase (2), the flow of the first dispersion phase (1) and the flow of the second dispersion phase (2) join at the connection site of the microflow channel (16-1) and the first slit (12), and the two-phase parallel continuous flow (4) of the first dispersion phase (1) and the second dispersion phase (2) is formed in the microflow channel (16-1) between the first slit (12) and the second slit (13).

When the microflow channel (16-1) is supplied with the continuous phase (3) from the continuous phase supply slit (14), the flow of the two-phase parallel continuous flow (4) is sheared by the flow of the continuous phase (3) as a driving force near the connection site of the continuous phase supply slit (14) with the microflow channel (16-1), whereby the two-phase droplets (5-1, 5-2) having a core-shell or Janus structure can be generated from the two phases of the first dispersion phase (1) and the second dispersion phase (2). In FIG. 6b, two types of two-phase droplets, a core-shell droplet (5-2) and a Janus droplet (5-1), are shown for explanation, but one type of two-phase droplets (5) such as core-shell droplets (5-2) or Janus droplets (5-1) are generated. In FIG. 6b, a core-shell droplet (5-2) having the second dispersion phase (2) as the core and the first dispersion phase (1) as the shell is shown, but it may be a core-shell droplet having the first dispersion phase (1) as the core and the second dispersion phase (2) as the shell.

The product containing the two-phase droplets (5) is discharged through the product discharge slit (13) and the product discharge port (13-1).

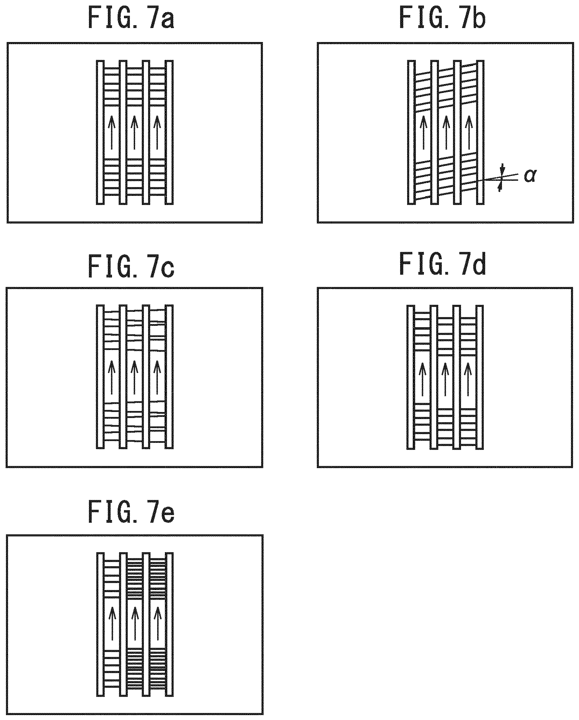

FIGS. 7a to 7e show examples of the shapes of the microgrooves processed in the liquid distributing part (33) of embodiments 3 to 4 of the present invention. Fig. 7a shows the case where four slits are bridged by a straight microgroove that intersects perpendicularly, FIG. 7b shows the case where they are bridged by obliquely intersecting linear microgrooves, and FIG. 7c shows the case where the widths of the bridging microgroove change continuously. Note that the widths of the microgrooves may change discontinuously. FIG. 7d shows the case where there is a deviation in the positions of the bridging microgrooves, and FIG. 7e shows the case where the number of bridging microgrooves does not correspond to 1: 1.

In embodiments 3 and 4 of the present invention, the sealing cover (21) is desirably composed of a transparent member such as silicone resin (PDMS: polydimethylsiloxane), acrylic resin, or glass. The liquid distribution device is produced by machining, for example, a stainless-steel material (SUS304). The slit-shaped through-holes of the liquid distribution device can be produced, for example, by wire electric discharge machining. The microgrooves bridging the slits can be produced by mechanical cutting, laser processing, or etching.

In embodiments 3 and 4 of the present invention, for example, core-shell two-phase droplets are generated by feeding a first dispersion phase such as silicone oil (SO), a second dispersion phase such as 1,6-hexanediol diacrylate (HDDA), and a continuous phase such as polyvinyl alcohol (PVA) aqueous solution. Janus two-phase droplets are generated by feeding a first dispersion phase such as 1,6-hexanediol diacrylate (HDDA), a second dispersion phase such as silicone oil having 1 wt% of a surfactant added thereto (SO + surfactant), and a continuous phase such as polyvinyl alcohol (PVA) aqueous solution. For example, a glass syringe and a syringe pump can be used to feed the dispersion phase and the continuous phase. For observing droplet generation and measuring the size of the generated droplets, it is suitable to use, for example, an upright optical microscope and a high-speed video camera in combination.

### (Embodiment 5)

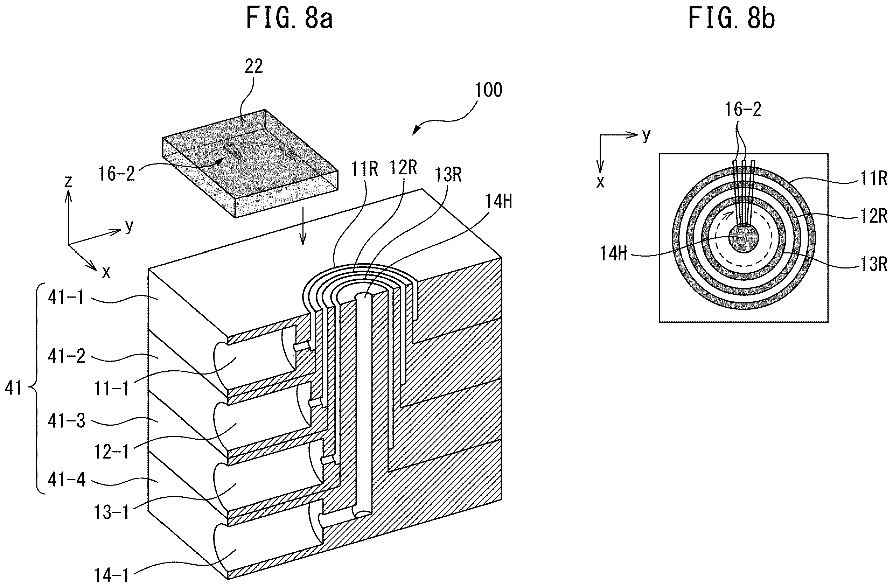

The micro two-phase droplet generating device (100) of embodiment 5 is composed of the microgroove array substrate (22) having microgrooves (16-2) formed therein, and the liquid distributing part (41) having three slits (11R, 12R, 13R) and a cylindrical pore (14H) (FIGS. 8a and 8b). The microgrooves (16-2) formed in the microgroove array substrate (22) are formed radially from the central axis line. The three slits (11R, 12R, 13R) formed in the liquid distributing part (41) are concentric rings and have the cylindrical pore (14H) along their central axis line.

The liquid distributing part (41) is composed of four members (FIGS. 8a and 8b). The liquid distributing part (41) comprises a topmost first member (41-1) comprising the first dispersion phase supply port (11-1) arranged at the bottom of the part (22) having the microgrooves (16-2); a second member (41-2) which is the second stage from the top, comprising a second dispersion phase supply port (12-1) and forming an annular slit (11R) for supplying the first dispersion phase (1) by combining with the first member (41-1); a third member (41-3), which is the third stage from the top, comprising the continuous phase supply port (13-1) and forming an annular slit (12R) for supplying the second dispersion phase (2) by combining with the second member (41-2); and a fourth member (41-4), which is the fourth stage from the top, which forms an annular slit (13R) for supplying the continuous phase (3) by combining with the third member (41-3) and which comprises a product discharge central cylindrical pore (14H) and the discharge port (14-1) (FIGS. 8a and 8b).

FIG. 8a shows a cross-sectional perspective view of the liquid distributing part (41) when the first to fourth members are combined. The supplied first dispersion phase (1), second dispersion phase (2), and continuous phase (3) flow from the lower layer through the annular slits (11R, 12R, 13R) and are supplied to the upper portion of the liquid distributing part (41). Specifically, the first dispersion phase (1) is supplied from the first dispersion phase supply port (11-1) to the first dispersion phase supply annular slit (11R) of the first member (41-1), the second dispersion phase (2) is supplied from the second dispersion phase supply port (12-1) to the second dispersion phase supply annular slit (12R) of the second member (41-2), the continuous phase (3) is supplied from the continuous phase supply port (13-1) to the continuous phase supply annular slit (13R) of the third member (41-3), and the first dispersion phase (1), the second dispersion phase (2), and the continuous phase (3) are fed upward in the respective slits.

In order to emphasize the shape of the annular slits (11R, 12R, 13R) and the cylindrical pore (14H), the annular slits (11R, 12R, 13R) and the cylindrical pore (14H) are shown separately from the first dispersion phase supply port (11-1), the second dispersion phase supply port (12-1), the continuous phase supply port (13-1), and the discharge port (14-1), but in the present disclosure, annular slits (11R, 12R, 13R) and cylindrical pore (14H) functionally constitute portions of the first dispersion phase supply port (11-1), the second dispersion phase supply port (12-1), the continuous phase supply port (13-1) and the discharge port (14-1), as described above (in the following aspects, the relationship of the annular slit and the cylindrical pore with the first dispersion phase supply port, the second dispersion phase supply port, the continuous phase supply port or the discharge port is the same, but will not be repeated).

A device wherein the three slits (i.e., the first dispersion phase supply slit (11R), the second dispersion phase supply slit (12R), and the continuous phase supply slit (13R)) and a cylindrical pore (14H), which is a portion of the discharge port (14-1), on the liquid distributing part (41), are joined with the part (22) having the microgrooves (16-2), is shown in FIG. 8a. In FIG. 8a, the first dispersion phase is supplied to the outer annular slit (11R), the second dispersion phase is supplied to the middle annular slit (12R), and the continuous phase (3) is supplied to the inner slit (13R).

The first dispersion phase (1) and the second dispersion phase (2) are supplied to the microflow channels (16-2) formed from the microgrooves (16-2) and form the two-phase parallel continuous flow (4) of the first dispersion phase (1) and the second dispersion phase (2) in the microflow channels (16-2) connecting the first dispersion phase supply slit (11R) and the second dispersion phase supply slit (12R). The continuous phase (3) is supplied to microflow channels (16-2), the two-phase droplets (5) are generated near the connection sites between the microflow channels (16-2) in which the two-phase parallel continuous flow (4) flows and the slit (13R) for continuous phase supply, and the two-phase droplets (5) pass through the microflow channels (16-2) and are discharged from the central cylindrical discharge port (14H).

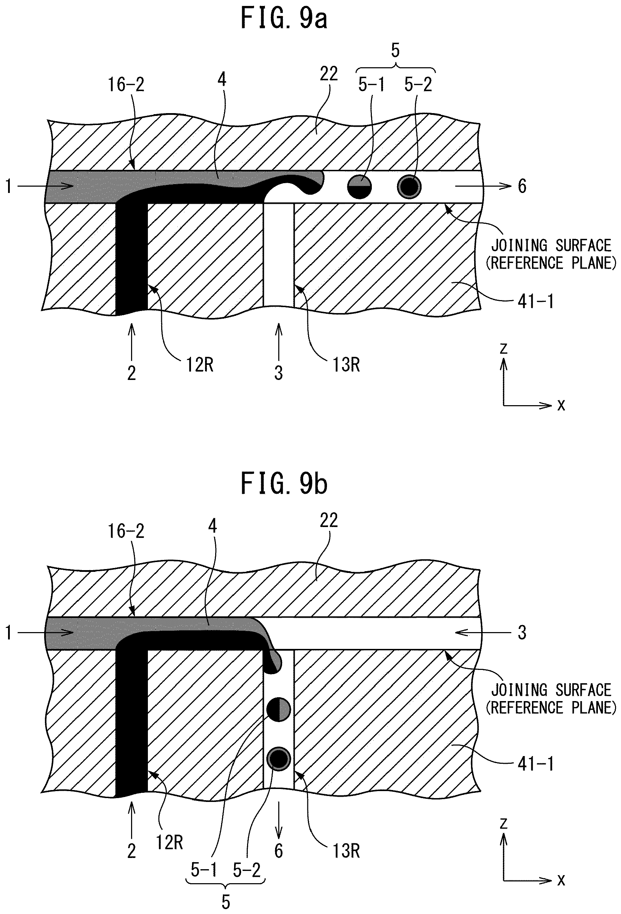

FIG. 9a shows an aspect in which two-phase droplets are generated in the device. When the microflow channel (16-2) is supplied with the first dispersion phase (1) from the left of FIG. 9a to form the flow of the first dispersion phase (1) and the second dispersion phase (2) from the first slit (12R) to form the flow of the second dispersion phase (2), the flow of the first dispersion phase (1) and the flow of the second dispersion phase (2) join at the connection site between the microflow channel (16-2) and the first slit (12R), and the two-phase parallel continuous flow (4) of the first dispersion phase (1) and the second dispersion phase (2) is formed in the microflow channel (16-2) between the first slit (12R) and the second slit (13R).

When the continuous phase (3) is supplied from the continuous phase supply slit (13R) to the microflow channel (16-2), the flow of the two-phase parallel continuous flow (4) is sheared by the flow of the continuous phase (3) as a driving force near the connection site of the microflow channel (16-2) with the continuous phase supply slit (13R), and two-phase droplets (5-1, 5-2) having a core-shell or Janus structure can be generated from the two phases of the first dispersion phase (1) and the second dispersion phase (2). In FIG. 9a, two types of two-phase droplets, a core-shell droplet (5-2) and a Janus droplet (5-1), are drawn for explanation, but one type of two-phase droplets (5) such as core-shell droplets (5-2) or Janus droplets (5-1) are generated. Furthermore, in FIG. 9a, a core-shell droplet (5-2) having the second dispersion phase (2) as the core and the first dispersion phase (1) as the shell is shown, but it may be a core-shell droplet having the first dispersion phase (1) as the core and the second dispersion phase (2) as the shell.

The product containing the two-phase droplets (5) is discharged through the cylindrical pore (14H) and the product discharge port (14-1).

### (Embodiment 6)

The micro two-phase droplet generating device (100) of embodiment 6 is similar to the micro two-phase droplet generating device (100) of embodiment 5, but differs in that the continuous phase supply slit and the cylindrical pore for product discharge of embodiment 5 are exchanged, and the continuous phase supply port and the product discharge port are exchanged. As a result, in FIGS. 8a and 8b, the slit (13R) is the product discharge slit, the cylindrical pore (14H) is the continuous phase supply cylindrical pore (opening), the liquid transfer port (13-1) is the product discharge port, and the liquid transfer port (14-1) is the continuous phase supply port.

In embodiment 6, the microflow channels (16-2) are supplied with the first dispersion phase (1) from the first dispersion phase supply slit (11R) and the second dispersion phase (2) from the second dispersion phase supply slit (12R), and as described below, the two-phase parallel continuous flow (4) is formed in the microflow channel (16-2) between the first slit (12R) and the second slit (13R), the continuous phase (3) is supplied from the continuous phase supply port (14-1) and the continuous phase supply cylindrical pore (14H), core-shell or Janus two-phase droplets (5) are generated near the connection site of the microflow channel (16-2) with the second slit (13), and the two-phase droplets (5) are discharged through the product discharge slit (13R) and the product discharge port (13-1).

FIG. 9b is a partial schematic diagram of a longitudinal cross-section of the micro two-phase droplet generating device (100) of the embodiment 6 taken along the longitudinal direction of one microflow channel (16-2), and schematically shows an aspect in which two-phase droplets are generated. In FIG. 9b, the microflow channel (16-2) is formed above the joining surface (reference plane) between the microgroove array substrate (22) and the liquid distributing part (41), and the slits (12R, 13R) extend vertically downward from the reference plane.

When the microflow channel (16-2) is supplied with the first dispersion phase (1) from the left in FIG. 9b to form the flow of the first dispersion phase (1) and the second dispersion phase (2) from the first slit (12R) to form the flow of the second dispersion phase (2), the flow of the first dispersion phase (1) and the flow of the second dispersion phase (2) join at the connection site between the microflow channel (16-2) and the first slit (12R), and the two-phase parallel continuous flow (4) of the first dispersion phase (1) and the second dispersion phase (2) is formed in the microflow channel (16-2) between the first slit (12R) and the second slit (13R).

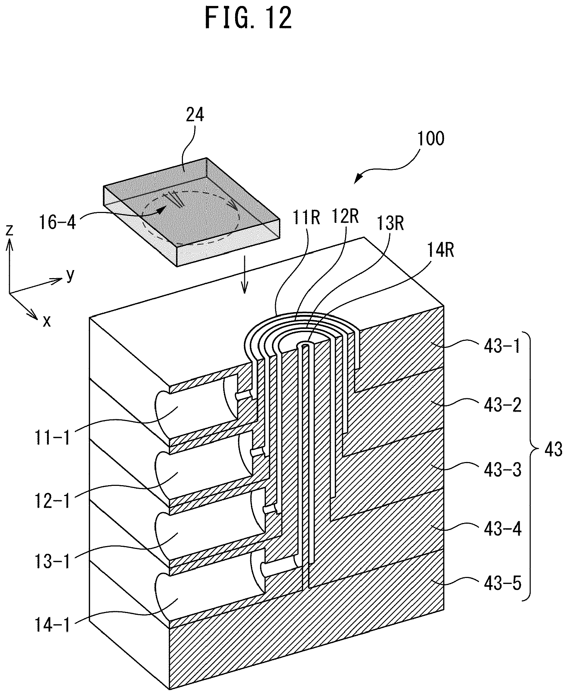

When the continuous phase (3) is supplied to the microflow channel (16-2) from the cylindrical pore (14H) for continuous phase supply to the microflow channel (16-2), the flow of the two-phase parallel continuous flow (4) is sheared by the flow of the continuous phase (3) as a driving force near the connection site with the microflow channel (16-2) of the discharge slit (13R), and two-phase droplets (5-1, 5-2) having a core-shell or Janus structure can be generated from the two phases of the first dispersion phase (1) and the second dispersion phase (2). In FIG. 12, two types of two-phase droplets, a core-shell droplet (5-2) and a Janus droplet (5-1), are drawn for explanation, but one type of two-phase droplets (5) such as core-shell droplets (5-2) or Janus droplets (5-1) are generated. Furthermore, in FIG. 9b, a core-shell droplet (5-2) having the second dispersion phase (2) as the core and the first dispersion phase (1) as the shell is shown, but it may be a core-shell droplet having the first dispersion phase (1) as the core and the second dispersion phase (2) as the shell.

The product containing the two-phase droplets (5) is discharged through the product discharge slit (13R) and the product discharge port (13-1).

### (Embodiment 7)

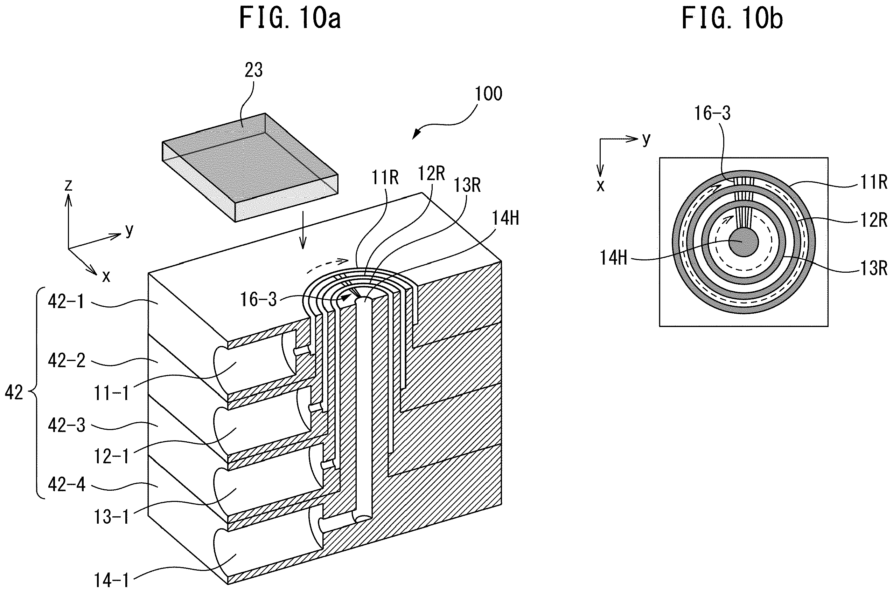

As shown in FIGS. 10a and 10b, in the micro two-phase droplet generating device (100) of embodiment 7, a row of a plurality of microgrooves (16-2) is formed on the top surface of the liquid distributing part (42) having three slits (11R, 12R, 13R) and a cylindrical pore (14H), and microflow channels (16-2) are formed by sealing the top surfaces of the plurality of microgrooves (16-2) with a cover (23). The bottom surface of the sealing cover (23) of the microgroove (16-2) is a flat plane. The microgrooves (16-2) formed in the liquid distributing part (42) are formed radially from the central axis line. Conversely, the three slits (11R, 12R, 13R) formed in the liquid distributing part (42) are concentric rings and have a cylindrical pore (14H) along their central axis line.

The liquid distributing part (42) is composed of four members (FIGS. 10a and 10b). The liquid distributing part (42) comprises: a topmost first member (42-1) which is arranged below the flat cover (23) for sealing the slits (11R, 12R, 13R), the discharge cylindrical pore (14H) and the microgrooves (16-3), and comprises the first dispersion phase supply port (11-1); a second member (42-2), which is the second stage from the top, which comprises the second dispersion phase supply port (12-1) and together with the first member (42-1), forms an annular slit (11R) for supplying the first dispersion phase (1); a third member (42-3), which is the third stage from the top, which comprises the continuous phase supply port (13-1) and together with the second member (42-2), forms an annular slit (12R) for supplying the second dispersion phase (2); and a fourth member (42-4), which is the fourth stage from the top, which together with the third member (42-3), forms an annular slit (13R) for supplying the continuous phase (3), and which comprises a cylindrical discharge pore (14H) along the center thereof.

The microgrooves (16-3) are processed between the annular slits (11R, 12R, 13R) formed by combining the four members and between the annular slit (13R) and the cylindrical pore (14H).

FIG. 10a shows a cross-sectional perspective view when the first to fourth members of the liquid distributing part (42) are combined. The supplied first dispersion phase (1), second dispersion phase (2), and continuous phase (3) flow from the lower layer through the annular slits (11R, 12R, 13R) and are supplied to the upper portion of the liquid distributing part (42). Specifically, the first dispersion phase (1) is supplied from the first dispersion phase supply port (11-1) to the first dispersion phase supply annular slit (11R) of the first member (42-1), the second dispersion phase (2) is supplied from the second dispersion phase supply port (12-1) to the second dispersion phase supply annular slit (12R) of the second member (42-2), the continuous phase (3) is supplied from the continuous phase supply port (13-1) to the continuous phase supply annular slit (13R) of the third member, and the first dispersion phase (1), the second dispersion phase (2), and the continuous phase (3) are fed upward in each slit.

A device in which the part (42) having the three slits (i.e., the first dispersion phase supply slit (11R), the second dispersion phase supply slit (12R) and the continuous phase supply slit (13R)) and a cylindrical pore (14H), which is a part of the discharge port (14-1), as well as the microgrooves (16-3) on the liquid distributing part (42) is joined with a flat part (23)is shown in FIG. 10a. In FIG. 10a, the first dispersion phase is supplied to the outer annular slit (11R), the second dispersion phase is supplied to the middle annular slit (12R), and the continuous phase (3) is supplied to the inner slit (13R).

The first dispersion phase (1) and the second dispersion phase (2) are supplied to the microflow channels (16-3) formed from the microgrooves (16-3), the two-phase parallel continuous flow (4) of the first dispersion phase (1) and the second dispersion phase (2) is formed in the microflow channels (16-3) connecting the first dispersion phase supply slit (11R) and the second dispersion phase supply slit (12R). The continuous phase (3) is supplied to the microflow channels (16-3), the two-phase droplets are generated near the connection site between the microflow channel (16-3) in which the two-phase parallel continuous flow (4) flows and the continuous phase supply slit (13R), and are discharged from the central cylindrical discharge pore (14H) through the microflow channels (16-3).

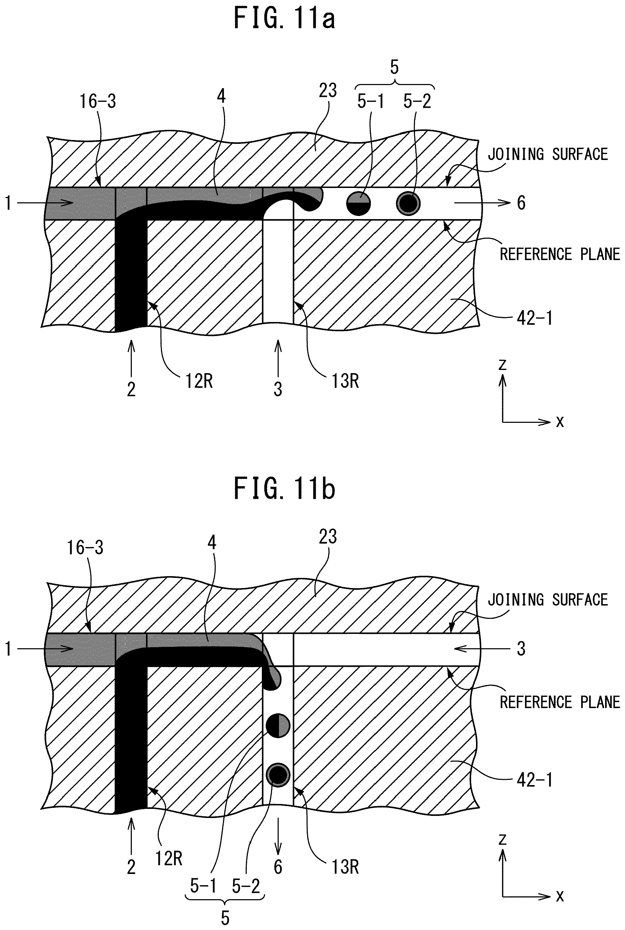

FIG. 11a is a partial schematic view of a longitudinal cross-section of the micro two-phase droplet generating device (100) of the embodiment 7 taken along the longitudinal direction of one microflow channel (16-3), and schematically shows an aspect in which two-phase droplets are generated. In FIG. 11a, the microflow channel (16-3) based on a microgroove is formed in the downward direction of the joining surface between the sealing cover (23) and the liquid distributing part (42), and the slits (12R, 13R) extend vertically downward from the microflow channel (16-3) as the reference plane, i.e., the bottom surface (lower surface) of the microgroove as the reference plane.

When the microflow channel (16-3) is supplied with the first dispersion phase (1) from the left in FIG. 11a to form the flow of the first dispersion phase (1) and the second dispersion phase (2) from the first slit (12R) to form the flow of the second dispersion phase (2), the flow of the first dispersion phase (1) joins the flow of the second dispersion phase (2) at the connection site of the microflow channel (16-3) and the first slit (12R), and the two-phase parallel continuous flow (4) of the first dispersion phase (1) and the second dispersion phase (2) is formed in the microflow channel (16-3) between the first slit (12R) and the second slit (13R).

When the continuous phase (3) is supplied from the continuous phase supply slit (13R) to the microflow channel (16-3), the flow of two-phase parallel continuous flow (4) is sheared by the flow of continuous phase (3) as a driving force in the microflow channel (16-3) near the connection site with the continuous phase supply slit (13R), and two-phase droplets (5) having a core-shell or Janus structure can be generated from the two phases of the first dispersion phase (1) and the second dispersion phase (2). In FIG. 11a, two types of two-phase droplets, a core-shell droplet (5-2) and a Janus droplet (5-1), are drawn for explanation, but in reality, one type of two-phase droplets (5) such as core-shell droplets (5-2) or Janus droplets (5-1) are generated. Furthermore, in FIG. 11a, a core-shell droplet (5-2) having the second dispersion phase (2) as the core and the first dispersion phase (1) as the shell is shown, but it may be a core-shell droplet having the first dispersion phase (1) as the core and the second dispersion phase (2) as the shell.

The product containing the two-phase droplets (5) is discharged through the product discharge cylindrical pore (14H) and the product discharge port (14-1).

### (Embodiment 8)

The micro two-phase droplet generating device (100) of embodiment 8 is similar to the micro two-phase droplet generating device (100) of embodiment 7, but differs in that the continuous phase supply slit and the product discharge cylindrical pore of embodiment 7 are exchanged and the continuous phase supply port and the product discharge port are exchanged. As a result, in FIGS. 10a and 10b, the slit (13R) is the product discharge slit, the cylindrical pore (14H) is the continuous phase supply cylindrical pore, the liquid transfer port (13-1) is the product discharge port, and the liquid transfer port (14-1) is the continuous phase supply port.

In embodiment 8, the microflow channel (16-3) is supplied with the first dispersion phase (1) from the first dispersion phase supply slit (11R) and the second dispersion phase (2) from the second dispersion phase supply slit (12R), the continuous phase (3) is supplied from the continuous phase supply port (14-1) and the continuous phase supply cylindrical pore (14H), and as described below, the two-phase parallel continuous flow (4) is formed in the microflow channel (16-3) between the first slit (12R) and the second slit (13R), two-phase droplets (5-1, 5-2) such as core-shell or Janus droplets are generated near the connection site of the microflow channel (16-3) with the second slit (13R), and the two-phase droplets (5-1, 5-2) are discharged through the product discharge slit (13R) and the product discharge port (13-1).

FIG. 11b is a partial schematic view of a longitudinal cross-section of the micro two-phase droplet generating device (100) of the embodiment 8 taken along the longitudinal direction of one microflow channel (16-3), and schematically shows an aspect in which two-phase droplets are generated. In FIG. 11b, the microflow channel (16-3) based on microgroove is formed in the downward direction of the joining surface between the sealing cover (23) and the liquid distributing part (42), and the slits (12R, 13R) extend vertically downward from the reference plane with the microflow channel (16-3), i.e., the virtual plane connecting the bottom (lower surface) of the microgrooves, as the reference plane.

When the microflow channel (16-3) is supplied with the first dispersion phase (1) from the left in FIG. 11b to form the flow of the first dispersion phase (1) and the second dispersion phase (2) from the first slit (12R) to form the flow of the second dispersion phase (2), the flow of the first dispersion phase (1) joins the flow of the second dispersion phase (2) at the connection site of the microflow channel (16-3) and the first slit (12R), and the two-phase parallel continuous flow (4) of the first dispersion phase (1) and the second dispersion phase (2) is formed in the microflow channel (16-3) between the first slit (12R) and the second slit (13R).

When the microflow channel (16-3) is supplied with the continuous phase (3) from the continuous phase supply cylindrical pore (14H), the flow of two-phase parallel continuous flow (4) is sheared by the flow of continuous phase (3) as a driving force near the connection site of the product discharge slit (13R) with the microflow channel (16-3), and two-phase droplets (5) having a core-shell or Janus structure can be generated from the two phases of the first dispersion phase (1) and the second dispersion phase (2). In FIG. 11b, two types of two-phase droplets, a core-shell droplet (5-2) and a Janus droplet (5-1), are drawn for explanation, but in reality, one type of two-phase droplets (5) such as core-shell droplets (5-2) or Janus droplets (5-1) are generated. Furthermore, in FIG. 11b, a core-shell droplet (5-2) having the second dispersion phase (2) as the core and the first dispersion phase (1) as the shell is shown, but it may be a core-shell droplet having the first dispersion phase (1) as the core and the second dispersion phase (2) as the shell.

The product containing the two-phase droplets (5) is discharged through the product discharge slit (13R) and the product discharge port (13-1).

### (Embodiment 9)

In embodiment 9, by constructing a liquid distribution part (43) using five members as shown in FIG. 12 so that the central cylindrical pore (14H) of the device used in embodiments 5 and 6 is configured as the annular slit (14R) and attaching the liquid distribution part (43) to the part (microgroove array substrate) (24) having microgrooves, droplets can be generated in the same manner.

The microgroove array substrate (24) is a part having microgrooves (16-4), and there are four annular slits (11R, 12R, 13R, 14R), each of which is connected to a supply port or discharge port (11-1, 12-1, 13-1, 14-1), and the liquid distribution part (43) is composed of a first member (43-1), a second member (43-2), a third member (43-3), a fourth member (43-4), and a fifth member (43-5).

### (Embodiment 10)

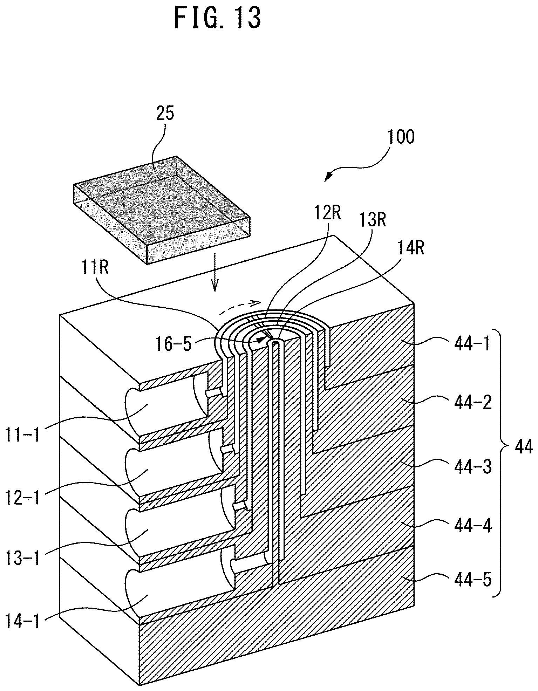

In embodiment 10, by constructing a liquid distribution part (44) using five members as shown in FIG. 13 so that the central cylindrical pore (14H) of the device used in embodiments 7 and 8 is configured as the annular slit (14R) and bonding the liquid distribution part (44) with sealing cover (25), droplets can be generated in the same manner.

Agan, there are four annular slits (11R, 12R, 13R, 14R), each of which is connected to a supply port or a discharge port (11-1, 12-1, 13-1, 14-1), and the liquid distribution part (44) is composed of a first member (44-1), a second member (44-2), a third member (44-3), a fourth member (44-4), and a fifth member (44-5).

Furthermore, in the present invention, the micro two-phase droplet generating device of the present invention can be used to generate micro two-phase droplets. Specifically, according to the present invention, a micro two-phase droplet generation method is also provided.

### EXAMPLES

The present invention will be described in further detail by way of the Examples below.

### (Example 1)

A droplet generation device (FIG. 2) composed of a parallelized straight microflow channel substrate (microgroove array substrate) having a rectangular cross-section and a liquid distributing part was designed, fabricated, and used. The microflow channel substrate consisted of 16 linear microflow channels having a rectangular cross section (width: 100 µm, height: 100 µm) and length of 13 mm, and the interval between channels was 100 µm. The liquid distributing part was constructed by laminating two members having a width of 30 mm, a length of 33 mm, and a height of 8 mm (FIG. 2). The upper member has a total of four slits including the first dispersion phase supply slit, the second dispersion phase supply slit (first slit), the continuous phase supply slit (second slit), and the product discharge (liquid collect) slit, and the lower member has a first dispersion phase supply port, a second dispersion phase supply port, a continuous phase supply port, and a product discharge port, which are connected to the respective slits of the upper member. The width of each slit was 500 µm, the length was 5 mm, and the pitch between the slits was 3 mm (FIG. 2b).

The microflow channel substrate was produced by transferring a pattern to polydimethylsiloxane (PDMS) from a mold having a height of 100 µm, which was produced using negative photoresist SU-8 (Nippon Kayaku), on a Si substrate. Silpot 184 (Dow Corning Toray) was used as the PDMS raw material. The two members of the liquid distributing part were produced by machining a stainless-steel material (SUS304). The slit-shaped through-holes of liquid distributing part (30) were produced by wire electric discharge machining. After bonding the microflow channel substrate and the liquid distributing part by oxygen plasma treatment, aqueous solution of poly(allylamine hydrochloride) (PAH) and poly(sodium 4-styrenesulfonate) (PSS), which are polymer electrolytes, were alternately introduced into the channels to hydrophilize the walls of the channels.

As introduction samples, a 2 wt% aqueous solution of polyvinyl alcohol (GL-03, Mitsubishi Chemical) was used as the continuous phase, silicone oil (SO, SH200-10CS, Toray Dow Corning) was used as the first dispersion phase, and 1,6-hexanediol diacrylate (HDDA, Shin-Nakamura Chemical Co., Ltd.) was used as the second dispersion phase. A 10 mL glass syringe (1000 series, Hamilton Company, USA) and a syringe pump (KDS200, KD Scientific, USA) were used for liquid feeding to the liquid distributing part. An upright microscope (BX-51, Olympus) and a high-speed video camera (FASTCAM Mini AX50, Photron) were used in combination to observe droplet generation in the microflow channels.

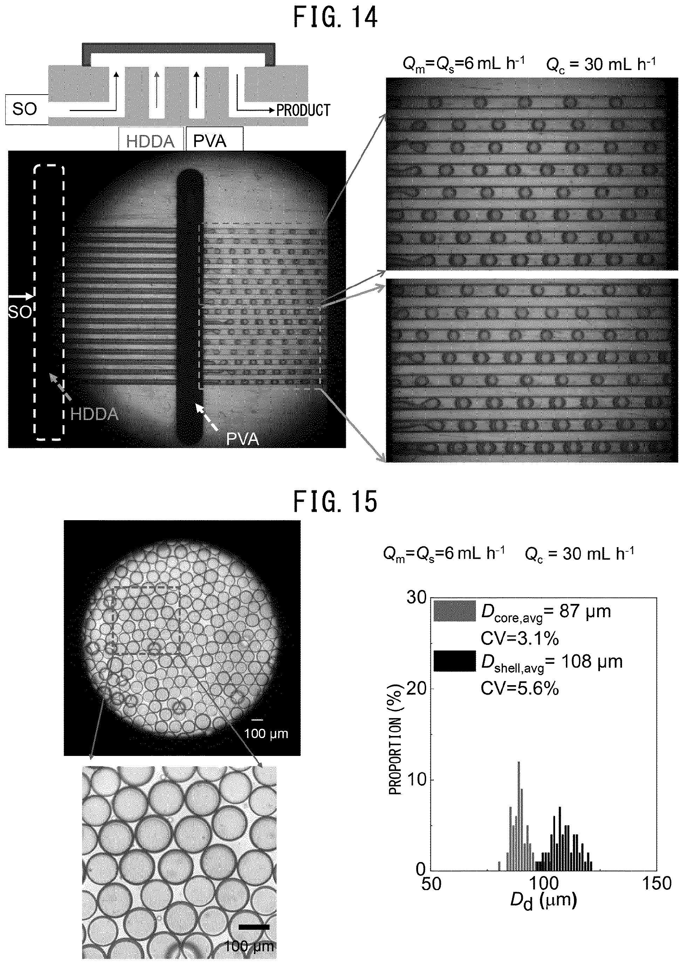

FIG. 14 shows the state of two-phase droplet generation within the parallelized microflow channels when the continuous phase flow rate (Qc) was set to 30 mL/h, the SO flow rate (Qs), which was the first dispersion phase, was set to 6 mL/h, and the HDDA flow rate (Qm), which was the second dispersion phase, was set to 6 mL/h. Two-phase droplets were generated near the connection sites between the microflow channels and the continuous phase supply slit. FIG. 15 shows the results of collecting the generated droplets outside the device and observing them. The generated droplets had a core-shell structure with SO as the core and HDDA as the shell, where encapsulated droplets had an average diameter of 87 µm and a coefficient of variation (CV value) of 3.1% and exterior droplets had an average diameter of 108 µm and a CV value of 5.6%.

### (Example 2)

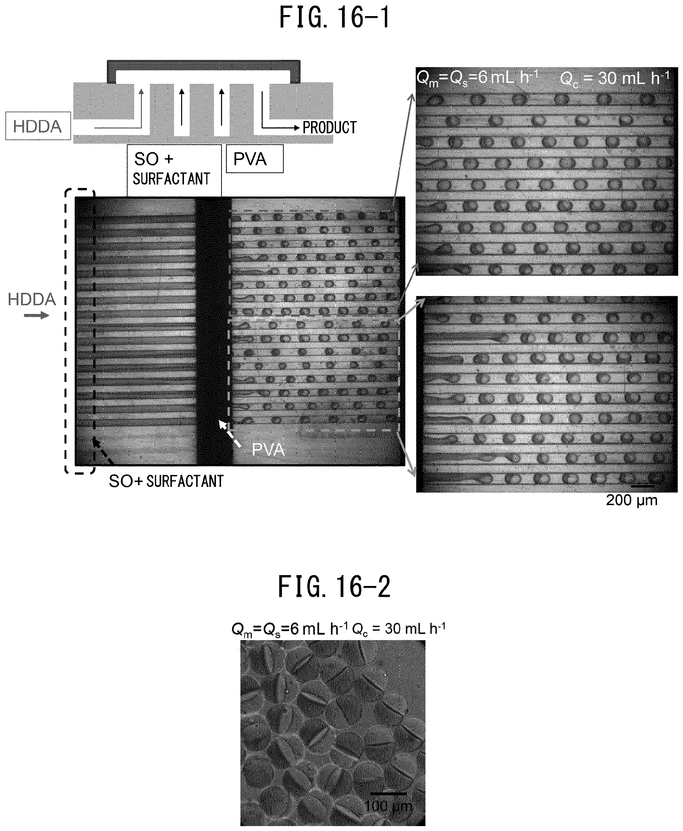

Using the same experimental devices as in Example 1, the experiment was conducted under the same conditions as in Example 1 except that the first dispersion phase was HDDA and the second dispersion phase was SO (SH200-10CS, Dow Corning Toray) to which 0.1 wt% of a surfactant (BY11-030, Dow Corning Toray) was added. FIG. 16-1 shows the state of two-phase droplet generation in the parallelized microflow channels. FIG. 16-2 shows the results of collecting the generated droplets outside the device and observing them. The generated droplets had a Janus structure in which the SO and HDDA phases were separated and were partially exposed to the continuous phase.

### (Example 3)

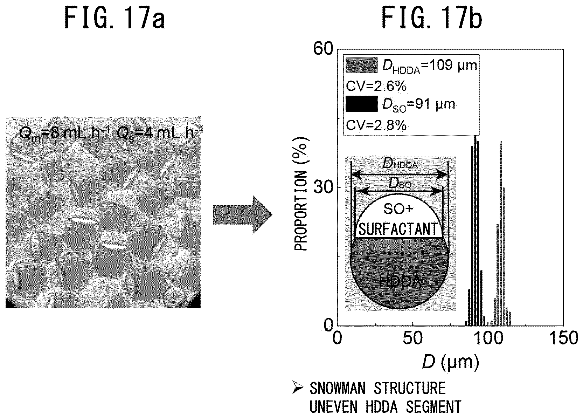

Using the same experimental devices as in Examples 1 and 2, the experiment was conducted under the same conditions as in Example 2 except that the flow rate (Qm) of HDDA, which was the first dispersion phase, was set to 8 mL/h, and the flow rate (Qs) of SO to which a surfactant was added, which was the second dispersion phase, was set to 4 mL/h. FIG. 17 shows the results of collecting the generated droplets outside the device and observing them. The generated droplets had a Janus structure in which the SO and HDDA phases were separated and were partially exposed to the continuous phase. The diameters of the SO and HDDA sites were measured as shown in FIG. 17, the HDDA sites had an average diameter of 109 µm and a CV value of 2.6%, and the SO sites had an average diameter of 91 µm and a CV value of 2.8%.

### INDUSTRIAL APPLICABILITY

According to the present invention, there can be provided a micro two-phase droplet generating device that does not require individual through-holes corresponding to the respective two-phase parallel continuous flow forming channels and two-phase droplet generation channels to connect the liquid distribution channels with the plurality of two-phase parallel continuous flow forming channels and two-phase droplet generation channels,

### DESCRIPTION OF REFERENCE SIGNS

1 first dispersion phase
2 second dispersion phase
3 continuous phase
4 two-phase parallel continuous flow
5 two-phase droplet
5-1 Janus droplet
5-2 core-shell droplet
6 product
11 first liquid transfer port (slit)
11R first liquid transfer port (annular slit)
11-1 first dispersion phase supply port
12 first slit
12R first slit (annular slit)
12-1 second dispersion phase supply port
13 second liquid transfer port (slit)
13R second liquid transfer port (annular slit)
13-1 continuous phase supply port or discharge port
14 third liquid transfer port (slit)
14R second opening (slit) (annular slit)
14H second opening (cylindrical pore)
14-1 discharge port or continuous phase supply port
16 (row of) microflow channels
16-1 (row of) microgrooves or microflow channels
16-2 (row of) microgrooves or microflow channels
16-3 (row of) microgrooves or microflow channels
16-4 (row of) microgrooves or microflow channels
16-5 (row of) microgrooves or microflow channels
20 microgroove array substrate (microflow channel array)
21 sealing cover
22 microgroove array substrate (microflow channel array)
23 sealing cover
24 microgroove array substrate (microflow channel array)
25 sealing cover
30 liquid distributing part
31 first member
32 second member
33 liquid distributing part
34 first member
35 second member
41 liquid distributing part
41-1 component member of liquid distributing part (first member)
41-2 component member of liquid distributing part (second member)
41-3 component member of liquid distributing part (third member)
41-4 component member of liquid distributing part (fourth member)
42 liquid distributing part
42-1 component member of liquid distributing part (first member)
42-2 component member of liquid distributing part (second member)
42-3 component member of liquid distributing part (third member)
42-4 component member of liquid distributing part (fourth member)
43 liquid distributing part
43-1 component member of liquid distributing part (first member)
43-2 component member of liquid distributing part (second member)
43-3 component member of liquid distributing part (third member)
43-4 component member of liquid distributing part (fourth member)
43-5 component member of liquid distributing part (fifth member)
44 liquid distributing part
44-1 component member of liquid distributing part (first member)
44-2 component member of liquid distributing part (second member)
44-3 component member of liquid distributing part (third member)
44-4 component member of liquid distributing part (fourth member)
44-5 component member of liquid distributing part (fifth member)

## Claims

1. A micro two-phase droplet generating device (100), comprising:
a row of a plurality of microflow channels (16), and
a first liquid transfer port (11), a first slit (12), a second liquid transfer port (13), and a third liquid transfer port (14) arranged in this order in a longitudinal direction of the microflow channels (16), wherein
"slit" is defined as a structure which has a linear end surface having a width and an axis line having a dimension larger than the width in a reference plane where the row of the plurality of microflow channels (16) is present, the row of the plurality of microflow channels (16) is present on the reference plane, the row of the plurality of microflow channels (16) is connected on the reference plane to the slit (12) having an end on the reference plane, and the slit (12) terminates at the reference plane and extends transversely below the reference plane,
the first slit (12) constitutes a part of a second phase dispersion phase supply port (12-1), the second liquid transfer port (13) constitutes a part of a continuous phase supply port or a discharge port, and the first slit (12) and the second liquid transfer port (13) terminate at connection sites with the plurality of microflow channels (16),
at the plane where the ends of the first slit (12) and the second liquid transfer port (13) are present, the plurality of microflow channels (16) are arranged so as to connect the end of the first liquid transfer port (11) and the end of the first slit (12), to connect the end of the first slit (12) and the end of the second liquid transfer port (13), and to connect the end of the second liquid transfer port (13) and the end of the third liquid transfer port (14), wherein the second liquid transfer port (13) is the continuous phase supply port or the discharge port, the third liquid transfer port (14) is the discharge port when the second liquid transfer port (13) is the continuous phase supply port, and the third liquid transfer port (14) is the continuous phase supply port when the second liquid transfer port (13) is the discharge port,
a first dispersion phase (1) is supplied from the first liquid transfer port (11) to the plurality of microflow channels (16), a second dispersion phase (2) is supplied from the first slit (12) to the plurality of microflow channels (16), wherein the first dispersion phase (1) and the second dispersion phase (2) are liquids which are not completely miscible with each other,
in the microflow channels (16) connecting the end of the first slit (12) and the end of the second liquid transfer port (13), the first dispersion phase (1) and the second dispersion phase (2) form a two-phase parallel continuous flow (4) which contains the two phases of the first dispersion phase (1) and the second dispersion phase (2) in parallel,
a continuous phase (3) is supplied to the plurality of microflow channels (16) from one of the second liquid transfer port (13) and the third liquid transfer port (14),
at the connection sites between the second liquid transfer port (13) and the plurality of microflow channels (16), two-phase droplets (5) are generated from the first dispersion phase (1) and the second dispersion phase (2), and
a product (6) containing the two-phase droplets (5) is collected from the other of the second liquid transfer port (13) and the third liquid transfer port (14).

2. The micro two-phase droplet generating device according to Claim 1, wherein the second liquid transfer port (13) is a second slit, the second slit (13) satisfies the above definition of a slit, and at connection sites between the second liquid transfer port (13) and the plurality of microflow channels (16), the two-phase parallel continuous flow (4) is sheared using a flow of the continuous phase (3) as a driving force to generate the two-phase droplets (5).

3. The micro two-phase droplet generating device according to Claim 1 or 2, wherein the two-phase droplets (5) are core-shell two-phase droplets.

4. The micro two-phase droplet generating device according to Claim 1 or 2, wherein the two-phase droplets (5) are Janus two-phase droplets.

5. The micro two-phase droplet generating device according to any one of Claims 1 to 4, wherein an end of the first liquid transfer port (11), an end of the second liquid transfer port (13), and/or an end of the third liquid transfer port (14) is/are slit-shaped.

6. The micro two-phase droplet generating device according to any one of Claims 1 to 5, wherein the slit(s) (11, 12, 13, 14) including the first slit (12) is/are a flat slit.

7. The micro two-phase droplet generating device according to any one of Claims 1 to 5, wherein the slit(s) (11, 12, 13, 14) including the first slit (12) is/are an annular slit.

8. The micro two-phase droplet generating device according to Claim 6 or 7, wherein a part (30, 41, 43) having the first slit (12) and a flat plate part (20, 22, 24) manufactured to have thereon a row of a plurality of microgrooves (16, 16-2, 16-4) are aligned with each other, and the plurality-of-slits-end surface of the part and a microgrooves-end surface of the flat plate part (20, 22, 24) are jointed together.

9. The micro two-phase droplet generating device according to Claim 6 or 7, wherein the row of the plurality of microgrooves (16) are manufactured on a surface of a part (33, 42, 44) having the first slit (12) and the microgrooves (16-1, 16-3, 16-5) are sealed by a separate flat plate part (21, 23, 25) to form the row of the plurality of microflow channels.

10. The micro two-phase droplet generating device according to any one of Claims 1 to 9, wherein inner walls of the microflow channels (16) are composed of hydrophilic surfaces, the first dispersion phase (1) is an organic phase, the second dispersion phase (2) is an organic phase, the continuous phase is an aqueous phase, and core-shell or Janus microdroplets are generated.

11. The micro two-phase droplet generating device according to any one of Claims 1 to 9, wherein an inner wall of the second liquid transfer port (13) is composed of hydrophilic surfaces, the first dispersion phase (1) is an organic phase, the second dispersion phase (2) is an organic phase, the continuous phase is an aqueous phase, and core-shell or Janus microdroplets are generated.

12. The micro two-phase droplet generating device according to any one of Claims 1 to 9, wherein inner walls of the microflow channels (16) connecting the end of the first slit (12) and the end of the second liquid transfer port (13) are composed of hydrophobic surfaces, inner walls of the microflow channels (16) connecting the end of the second liquid transfer port (13) and the end of the third liquid transfer port (14) are composed of hydrophilic surfaces, one of the first dispersion phase (1) and the second dispersion phase (2) is an aqueous phase, the other is an organic phase, the continuous phase (3) is an aqueous phase, the continuous phase (3) is supplied from the second liquid transfer port (13) to the microflow channels (16), and core-shell microdroplets having an aqueous phase as a core and an organic phase as a shell are generated.

13. The micro two-phase droplet generating device according to any one of Claims 1 to 9, wherein inner walls of the microflow channels (16) connecting the end of the first slit (12) and the end of the second liquid transfer port (13) are composed of hydrophobic surfaces, an inner wall of the second liquid transfer port (13) is composed of a hydrophilic surface, one of the first dispersion phase (1) and the second dispersion phase (2) is an aqueous phase, the other is an organic phase, the continuous phase (3) is an aqueous phase, the continuous phase (3) is supplied from the third liquid transfer port (14) to the microflow channels (16), and core-shell microdroplets having an aqueous phase as a core and an organic phase as a shell are generated.

14. The micro two-phase droplet generating device according to any one of Claims 1 to 3 and 5 to 13, wherein when the first dispersion phase is defined as phase 1, the continuous phase is defined as phase 2, and the second dispersion phase is defined as phase 3, the interfacial tension between the phases 1 and 2 is denoted as γ₁₂, the interfacial tension between the phases 1 and 3 is denoted as γ₁₃, and the interfacial tension between the phases 2 and 3 is denoted as γ₂₃, γ₁₂ > γ₂₃; a spreading parameter Si defined by Sᵢ = γⱼₖ - (γᵢⱼ + γₖᵢ) [where i, j and k are one of 1, 2 and 3 and are different from each other] is S₁ < 0, S₂ < 0, and S₃ > 0; and core-shell microdroplets are generated.

15. The micro two-phase droplet generating device according to any one of Claims 1, 2, and 4 to 11, wherein when the first dispersion phase is defined as phase 1, the continuous phase is defined as phase 2, and the second dispersion phase is defined as phase 3, the interfacial tension between the phases 1 and 2 is denoted as γ₁₂, the interfacial tension between the phases 1 and 3 is denoted as γ₁₃, and the interfacial tension between the phases 2 and 3 is denoted as γ₂₃, γ₁₂ > γ₂₃; a spreading parameter Si defined by Sᵢ = γⱼₖ - (γᵢⱼ + γₖᵢ) [where i, j and k are one of 1, 2 and 3 and are different from each other] is S₁ < 0, S₂ < 0, and S₃ < 0; and Janus microdroplets are generated.
